(19) Europäisches Patentamt / European Patent Office / Office européen des brevets

(11) **EP 4 205 284 B1**

(12) **EUROPEAN PATENT SPECIFICATION**

(45) Date of publication and mention
of the grant of the patent:
**25.06.2025 Bulletin 2025/26**

(21) Application number: **20838098.0**

(22) Date of filing: **23.12.2020**

(51) International Patent Classification (IPC):
$H03M\ 13/29^{(2006.01)}$   $H03M\ 13/13^{(2006.01)}$
$H03M\ 13/09^{(2006.01)}$

(52) Cooperative Patent Classification (CPC):
**H03M 13/13; H03M 13/2906;** H03M 13/09

(86) International application number:
**PCT/EP2020/087808**

(87) International publication number:
**WO 2022/135719 (30.06.2022 Gazette 2022/26)**

(54) **STAIRCASE POLAR ENCODING AND DECODING**

KODIERUNG UND DEKODIERUNG VON POLAR-TREPPENCODES

CODAGE ET DÉCODAGE DE CODE POLAIRE EN ESCALIER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.07.2023 Bulletin 2023/27**

(73) Proprietor: **Huawei Technologies Co., Ltd.
Shenzhen, Guangdong 518129 (CN)**

(72) Inventors:
• **BIOGLIO, Valerio
80992 Munich (DE)**
• **LAND, Ingmar
80992 Munich (DE)**
• **CONDO, Carlo
80992 Munich (DE)**

(74) Representative: **Roth, Sebastian
Mitscherlich PartmbB
Patent- und Rechtsanwälte
Karlstraße 7
80333 München (DE)**

(56) References cited:
• **CONDO CARLO ET AL: "Staircase Construction with Non-Systematic Polar Codes", 2020 OPTICAL FIBER COMMUNICATIONS CONFERENCE AND EXHIBITION (OFC), OSA, 8 March 2020 (2020-03-08), pages 1 - 3, XP033767200, DOI: 10.1364/OFC.2020.TH1G.6**
• **FENG BOWEN ET AL: "A Novel High-Rate Polar-Staircase Coding Scheme", PROC., IEEE 88TH VEHICULAR TECHNOLOGY CONFERENCE (VTC-FALL), IEEE, 27 August 2018 (2018-08-27), pages 1 - 5, XP033535199, DOI: 10.1109/VTCFALL.2018.8690625**
• **BIOGLIO VALERIO ET AL: "Construction and Decoding of Product Codes with Non-Systematic Polar Codes", 2019 IEEE WIRELESS COMMUNICATIONS AND NETWORKING CONFERENCE (WCNC), IEEE, 15 April 2019 (2019-04-15), pages 1 - 6, XP033652357, DOI: 10.1109/WCNC.2019.8886100**

## Description

TECHNICAL FIELD

Generally, the present disclosure relates to data encoding and data decoding in a communication system. Specifically, the disclosure relates to data encoding and data decoding using polar codes. The disclosure proposes an apparatus for staircase polar code encoding, an apparatus for staircase polar code decoding, and corresponding methods.

BACKGROUND

Channel codes are essential in a digital communication system. A system for forward error correction (FEC) coding, also called a coding scheme, consists of an encoder at the transmitter side and a decoder at the receiver side. The encoder can be configured to add redundancy to the data to be transmitted, i.e., it may add additional redundant data, and the decoder can exploit this redundancy to correct transmission errors. In this way, the receiver can, ideally, obtain the transmitted data free of errors despite a noisy communication channel between the transmitter and the receiver, over which the data is transmitted.

In particular, the data to be transmitted, also referred to as information word, is given as input to the encoder, which encodes the information word to produce a codeword that may contain the redundancy. This codeword is then transmitted over the noisy communication channel, which typically introduces errors. An output vector from the channel is provided to the decoder, and the decoder may produce estimates of the transmitted codeword, and thus of the transmitted data. The set of possible codewords is called the code, or in this case the channel code.

Polar codes are linear block codes, which rely on a polarization effect allowing to sort the bit positions of the information word, called bit-channels, in order of reliability. As the code length goes towards infinity, the polarization phenomenon influences the reliability of the bit-channels, and the bit-channels are either completely noisy or completely noiseless. In particular, the fraction of noiseless bit-channels equals the channel capacity.

For finite practical code lengths, the polarization of the bit-channels is incomplete. Therefore, there are bit-channels that are partially noisy. The polar encoding process consists in the classification of the bit-channels in the information word into two groups: K bit-channels that will carry information bits and are indexed by an information set I (including information bits), and $N - K$ bit-channels that are fixed to a predefined value (usually 0) and are indexed by a frozen set F (including frozen bits). In case of finite code lengths, the K most reliable bit-channels, i.e. the ones with the highest reliability, are selected to form the information set $I$, while the remaining bit-channels form the frozen set F.

A polar code may be based on the following kernel matrix:

$$T_2 = \begin{bmatrix} 1 & 0 \\ 1 & 1 \end{bmatrix}.$$

Encoding such a polar code of length $N = 2^n$ and information length $K$ is described in the following. The frozen set F of size $N-K$ is chosen as described above. The bits $u_i$ of the information word u are set to 0 for $i \in F$ and to the information bits otherwise. The codeword $x$ is computed as $x = uT$ with the transformation matrix $T = T_2^{\otimes n}$ denoting the $n$-fold Kronecker product.

Polar code decoding can be based on a Successive Cancellation (SC) decoding algorithm, which is inherently sequential. It can be viewed as a binary tree search, wherein bits are estimated at leaf nodes, and the tree is traversed depth-first, with priority given to the left branch. In SC decoding, the decoder starts with a decision for bit $u_1$ and feeds this decision back into the decoding process. Then, it makes a decision for bit $u_2$ and feeds this decision back into the decoding process. The decoder is configured to perform these steps until it obtains the design for the last bit $u_N$. SC list decoding (SCL) is an enhanced version of SC, wherein the decision is postponed to the end of the decoding process and is usually performed with the help of a cyclic-redundancy-check (CRC).

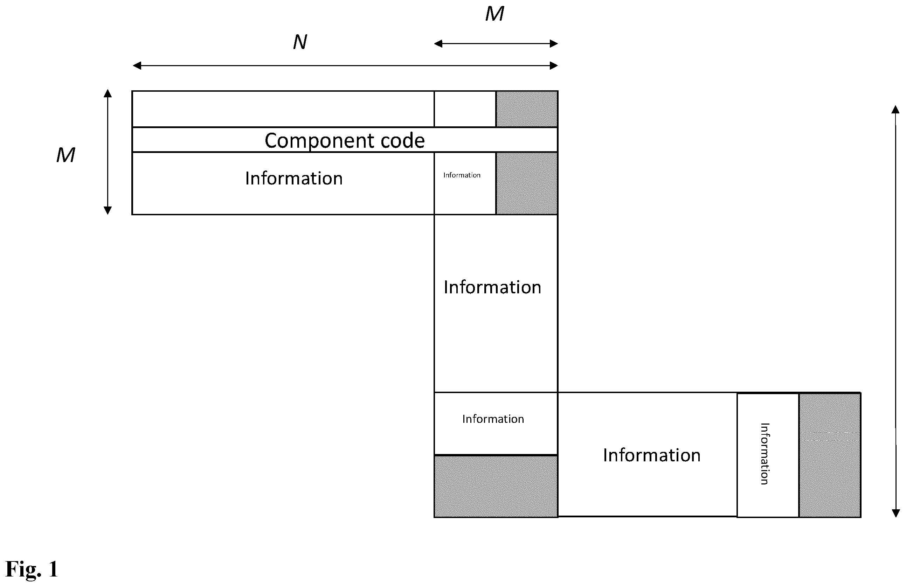

Staircase code constructions were introduced targeting 300 Gb/s optical transport networks. They take inspiration from both product codes and convolutional codes, in that they combine the use of a block code as a component code, and entangle a part of it with past and future codewords, thereby alternating row and column encoding or decoding. Fig. 1 depicts a straightforward example of such a staircase code.

The staircase code takes its name from the graphical representation of the encoding structure shown in Fig. 1. Therein, encoding and transmission proceeds from the top left of Fig. 1 towards the bottom right. Bits belonging to multiple component codes are transmitted only once. When interpreted by this graphical representation, a staircase code natively makes use of systematic component codes in the code construction.

Assuming systematic, in particular, component codes of length N with K information bits and N - K parity bits (i.e., of rate K/N), then in each horizontal or vertical encoding step, M x K bits are encoded into M x (N - K) parity bits. Note that out of these M x K bits, M x M are encoded earlier, and M x (K - M) are new source bits. Thus, the staircase code rate is (K - M)/(N - M). The straightforward construction imposes M = N/2. The component codes are usually selected among algebraic codes like Bose-Chaudhuri-Hocquenghem (BCH) and Reed-Solomon, and are chosen in their systematic form.

Decoding of a staircase code starts from the newest received blocks propagating information towards the older blocks. A decoding window of a number of blocks is selected for practical reasons, identifying the number of blocks through which the decoding information is propagated. Every time a new block is received, the oldest block in the window is output. Staircase code decoding is possible both as hard-decoding and soft decoding. Hard-decoding requires the decoding of component codes to return hard decisions, and the information propagated is the value of the bit itself. Soft-decoding requires component code decoders to return soft values, which are scaled and propagated through the window. Hard decisions are taken only at output time. Soft-decoding can achieve a substantially better error-correction performance than hard-decoding, at the cost of increased decoding complexity.

Preliminary results with staircase codes using polar codes have been presented. In particular, systematic polar codes are considered. Systematic polar codes are straightforward, but come with the disadvantage of increased encoding and decoding latency, that can be critical in optical communications.

Further, an error rate performance of staircase polar codes may be improved by applying conventional techniques used to improve polar and staircase codes independently. However, how to implement these techniques over staircase polar codes, i.e. over a merge of staircase and polar codes, is not straightforward.

CONDO CARLO ET AL: "Staircase Construction with Non-Systematic Polar Codes", Proc., OPTICAL FIBER COMMUNICATIONS CONFERENCE AND EXHIBITION (OFC), OSA, pages 1-3, discloses a staircase construction based on non-systematic polar codes, defining a specific interleaver.

SUMMARY

In view of the above, an objective of the present disclosure is to improve the conventional staircase encoding and staircase decoding using polar codes, i.e., to improve conventional staircase polar code encoding and staircase polar code decoding.

To this end, the disclosure proposes apparatuses and methods that employ a staircase code using non-systematic polar codes as component codes. Furthermore, the disclosure also bases on the following considerations.

In an example of a staircase code using non-systematic polar codes, considered by the inventors, the decoding may be based on a decoding window, i.e., a data structure that stores information relative to the latest received frame and a number of past ones. The decoding window may be successively updated through the output of component decoders, and every time a new frame is received, one of the frames in the window is replaced, usually the oldest. In general, the type of information stored in the decoding window depends on both the component decoder and the staircase decoder itself.

Given that most polar code decoding algorithms require soft input information, and that soft message passing improves the effectiveness of the staircase code decoding, it may be assumed that component codes are decoded with soft-in soft-out algorithms, and that soft information is represented as logarithmic-likelihood-ratios (LLR).

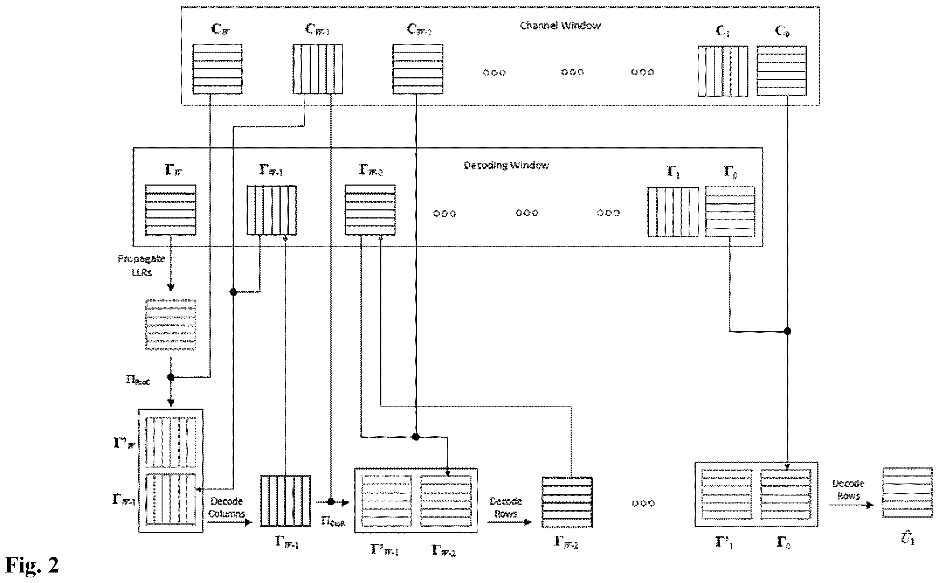

In particular, as shown in Fig. 2, in said example of staircase polar code decoding at a decoder, a decoding window is constituted of $W + 1$ matrices $C_k$, $0 \leq k \leq W$. Each of these matrices stores one frame of LLR coming from the channel between the transmitter (encoder) and receiver (decoder), and $W + 1$ matrices $\Gamma_k$, $0 \leq k \leq W$, where updated (extrinsic) soft information is stored. The matrices $C_k$ and $\Gamma_k$ represent LLR corresponding to the transmitted block $X_k$. While the decoding window can be implemented as a circular buffer, it can be considered that the last received frame is stored in $C_W$ and the oldest frame is that in $C_0$. Within the decoding window, the decoder proceeds from the newest block (received last) to the oldest blocks. In the following, the decoding for the newest block is elucidated, and decoding of the other blocks follows the same scheme.

It may be assumed for the decoder, that the last two encoding steps at an encoder were the following. After column-encoding at the encoder expressed by:

$$\begin{bmatrix} U_W \\ X'_{W-1} \end{bmatrix} \longrightarrow \begin{bmatrix} X'_W \\ X_{W-1} \end{bmatrix}$$

$X_{W-1}$ was transmitted to the decoder. The block $X_W^0$ was then used in the following row-encoding at the encoder expressed by

$$\begin{bmatrix} U_{W+1} & X'_W \end{bmatrix} \longrightarrow \begin{bmatrix} X'_{W+1} & X_W \end{bmatrix}$$

after which $X_W$ was transmitted to the decoder. Upon this transmission over a noisy channel and reception of the noisy observations of $X_W$ at the decoder, the corresponding channel LLR $C_W$ are stored, and the soft information matrix $\Gamma_W$ is initialized to zero. The soft information $C_k$ and $\Gamma_k$, where $k < W$, is available in a memory. The goal is to decode $\begin{bmatrix} X'_W & X_{W-1} \end{bmatrix}$.

For the decoding, soft information about the blocks $X_W^0$ and $X_{W-1}$ is required. The LLR in the blocks $C_W$ and $\Gamma_W$ are relative to the encoded matrix $X_W$, and $C_{W-1}$ and $\Gamma_{W-1}$ are relative instead to $X_{W-1}$. The posterior LLRs for the blocks $X_{W-1}$ and $X_W$ is given by $\Lambda_W = C_W + \Gamma_W$ and $\Lambda_{W-1} = C_{W-1} + \Gamma_{W-1}$, respectively. Now, from the soft information $\Lambda_W$ relative to $X_W$, soft information $\Lambda^0_W$ relative to $X_W^0$ can be computed.

By construction, $X_W = X_W^0 G^{\otimes(n-1)}$, wherein $G^{\otimes(n-1)}$ represents a polar transform. As the polar transform $G^{\otimes(n-1)}$ is an involution, i.e., identical to its inverse, also $X_W^0 = X_W \cdot G^{\otimes(n-1)}$ is obtained, which represents the encoder inverse. Thus, every row of $X_W^0$ can be com-

puted by multiplying the corresponding row of $X_W$ with the transformation matrix $G^{\otimes(n-1)}$, an operation commonly represented by a tanner graph constituted of stages of XORs. To propagate soft information, the same tanner graph structure can be used, substituting a $\tilde{f}$ operator for the XORs.

In the present example, the LLR propagation can beneficially be concatenated with an interleaver, which rotates the obtained $\Lambda^0_W$ so that they can be prepended to $\Lambda_{W-1}$. Each column of A can be used as an input to the component decoder, which returns extrinsic values, which are collected into matrices $\tilde{\Gamma}^0_W$ and $\tilde{\Gamma}_{W-1}$. The block $\tilde{\Gamma}_{W-1}$ is used to update the memory and also for decoding in the following decoding step. The block $\tilde{\Gamma}^0_W$ may be processed in the reverse way as above to determine $\tilde{\Gamma}_W$, which is used to update the memory.

The use of the above-mentioned interleaver at the decoder implies that a corresponding interleaver may also be used between the row-encoding and column-encoding phases at the encoder.

However, staircase constructions with algebraic component codes rely on the fact that all bits in the component codewords have the same probability of error. An arbitrarily selected interleaver may not take into account that serial decoding algorithms, like those based on SC, return estimated vectors with unevenly distributed probability of errors. Since the estimation of bit *i* relies on the correct estimation of previous bits *j < i,* its probability of error is approximately:

$$P_e^i \lessapprox P_{1e}^i + \frac{1}{2}\sum_{j=0}^{i-1} P_{1e}^j$$

where $P_{1e}^j$ is the probability of making the first decoding mistake, when estimating the bit *j*, as determined during the frozen set design.

After a decoding phase (row-decoding), the arbitrarily selected interleaver could thus distribute resulting error probabilities such that for the following decoding phase (column-decoding) each component codeword is composed of bits with the same $P_e$. This would lead to large variations in the probability of errors among different codewords, which would negatively impact the overall error correction capability of the staircase code.

A further objective of the present disclosure is therefore to provide apparatus and methods for staircase polar code encoding and staircase polar code decoding, respectively, that avoid this drawback. In particular, the performance of the decoder should be improved. Accordingly, it is a goal of this disclosure to improve the error correction capability of the staircase polar code. In particular, it is a goal to avoid large variations in the probability of errors among different codewords at the decoder.

The above and other objectives are achieved by the embodiments provided in the enclosed independent claims. Advantageous implementations of these embodiments are further defined in the dependent claims. In the following, parts of the description and drawings referring to embodiments which are not covered by the claims are not presented as embodiments of the invention, but as examples useful for understanding the invention.

In particular, this disclosure proposes a staircase code using non-systematic polar codes as component codes with specific interleavers.

According to a first aspect, the disclosure relates to an apparatus for staircase polar code encoding an input sequence of message bits into a sequence of matrices, wherein the staircase polar code encoding comprises two or more encoding steps. The apparatus is configured to perform a first encoding step of the two or more encoding steps by: generating a first matrix having a size MxN, where M=N/2, wherein, in each row of the first matrix, each bit position $x_{i,j}$ of the first matrix for $0 \le j < M$ contains an information bit or a frozen bit depending on a set of frozen bit indices F of a polar code of length N, where i is a row index and j is a column index, and wherein the bit positions $x_{i,j}$ of the first matrix for $0 \le i < M$ and $0 \le j < M$ form a first sub-matrix and the bit positions $x_{i,j}$ of the first matrix for $0 \le i < M$ and $M \le j < N$ form a second sub-matrix; encoding each row of the first matrix using the polar code of length N to obtain a first encoded matrix, wherein bit positions $x_{i,j}$ of the first encoded matrix for $0 \le i < M$ and $0 \le j < M$ form a first encoded sub-matrix and the bit positions $x_{i,j}$ of the first encoded matrix for $0 \le i < M$ and $M \le j < N$ form a second encoded sub-matrix; interleaving the first encoded sub-matrix to obtain a first interleaved sub-matrix; and transmitting the second encoded sub-matrix. The apparatus is further configured to perform a second encoding step of the two or more encoding steps based on the first interleaved sub-matrix.

The apparatus of the first aspect provides an improved staircase encoding using polar codes. Further, the interleaver may provide the advantage that the performance of staircase polar decoding at the decoder can be improved. In particular, the error correction capability of the staircase code can be improved, as large variations in the probability of errors among different codewords can be avoided by selecting the interleaver based on the above considerations.

In the first aspect, the apparatus is configured to interleave the first encoded sub-matrix by: performing a 90° clockwise rotation of the first encoded sub-matrix and a column index shift of the bit positions $x_{i,j}$ of each of the rows of the rotated first encoded sub-matrix.

With such an interleaver, the performance of staircase polar decoding at the decoder can be improved as described above. The interleaver provides a good tradeoff between performance and low complexity.

In the first aspect, the apparatus is further configured to perform the second encoding step by: generating a second matrix having a size NxM, wherein, in each column of the second matrix, each bit position $x_{i,j}$ for

$0 \leq i < N$ contains an information bit or a frozen bit depending on the set of frozen bit indices F of the polar code of length N, and wherein the bit positions $x_{i,j}$ of the second matrix for $0 \leq j < M$ and $0 \leq i < N$ form a third sub-matrix and the bit positions $x_{i,j}$ for $0 \leq j < M$ and $N \leq i < N$ form a fourth sub-matrix, which is equal to the first interleaved sub-matrix; encoding each column of the second matrix using the polar code of length N to obtain a second encoded matrix, wherein bit positions $x_{i,j}$ of the second encoded matrix for $0 \leq j < M$ and $0 \leq i < N$ form a third encoded sub-matrix and the bit positions $x_{i,j}$ of the second encoded matrix for $0 \leq j < M$ and $N \leq j < N$ form a fourth encoded sub-matrix; interleaving the third encoded sub-matrix to obtain a second interleaved sub-matrix; and transmitting the fourth encoded sub-matrix. The apparatus is further configured to perform a third encoding step based on the second interleaved sub-matrix.

In an implementation form of the first aspect, the apparatus is configured to interleave the third encoded sub-matrix by: performing a 90° counterclockwise rotation of the third encoded sub-matrix and a transposition of the rotated third encoded sub-matrix, or performing a 90° counterclockwise rotation of the third encoded sub-matrix and a row index shift of the bit positions $x_{i,j}$ of each of the rows of the rotated third encoded sub-matrix.

In an implementation form of the first aspect, the apparatus is configured to interleave the third encoded sub-matrix by performing a random permutation of the bit positions $x_{i,j}$ of the third encoded sub-matrix.

In an implementation form of the first aspect, the apparatus is configured to interleave the third encoded sub-matrix by performing a permutation of the bit positions $x_{i,j}$ of the third encoded sub-matrix, wherein the permutation is based on a determined decoding method, and wherein the frozen bits are arranged at bit positions $x_{i,j}$ that are related to bit positions having a highest decoding error probability in the decoding method.

The above implementation forms for the second encoding step provide the same advantages as described above for the first encoding step.

In an implementation form of the first aspect, the apparatus is configured to perform the third encoding step by: generating a third matrix of a size MxN, wherein, in each row of the third matrix, each bit position $x_{i,j}$ for $0 \leq j < M$ contains an information bit or a frozen bit depending on the set of frozen bit indices F of the polar code of length N, and wherein the bit positions $x_{i,j}$ for $0 \leq i < M$ and $0 \leq j < M$ form a fifth sub-matrix and the bit positions $x_{i,j}$ for $0 \leq i < M$ and $M \leq j < N$ form a sixth sub-matrix equal to the second interleaved sub-matrix; encoding each row of the third matrix using the polar code of length N to obtain a third encoded matrix, wherein bit positions $x_{i,j}$ of the third encoded matrix for $0 \leq i < M$ and $0 \leq j < M$ form a fifth encoded sub-matrix and the bit positions $x_{i,j}$ of the third encoded matrix for $0 \leq i < M$ and $M \leq j < N$ form a sixth encoded sub-matrix; interleaving the fifth encoded sub-matrix to obtain a third interleaved sub-matrix; and transmitting the sixth encoded sub-matrix. The apparatus is further configured to perform a fourth encoding step based on the third interleaved sub-matrix.

In an implementation form of the first aspect, the apparatus is configured to interleave the fifth encoded sub-matrix by: performing a 90° clockwise rotation of the fifth encoded sub-matrix and a transposition of the rotated fifth encoded sub-matrix, or performing a 90° clockwise rotation of the fifth encoded sub-matrix and a column index shift of the bit positions $x_{i,j}$ of each of the rows of the rotated fifth encoded sub-matrix.

In an implementation form of the first aspect, the apparatus is configured to interleave the fifth encoded sub-matrix by performing a random permutation of the bit positions $x_{i,j}$ of the fifth encoded sub-matrix.

In an implementation form of the first aspect, the apparatus is configured to interleave the fifth encoded sub-matrix by performing a permutation of the bit positions $x_{i,j}$ of the fifth encoded sub-matrix, wherein the permutation is based on a determined decoding method, and wherein the frozen bits are arranged at the bit positions $x_{i,j}$ related to bit positions having the highest decoding error probability in the decoding method.

The above implementation forms for the third encoding step provide the same advantages as described above for the second encoding step.

In an implementation form of the first aspect, in each row of the first matrix, each bit position $x_{i,j}$ of the first matrix for $M \leq j < N$ is set to 0.

This provides the advantage that the first matrix can be initialized in a simple way.

In an implementation form of the first aspect, an information bit is a message bit of the input sequence or a redundancy bit calculated based on the message bits of the input sequence.

This provides the advantage that CRC may be used.

In an implementation form of the first aspect, the apparatus is configured to perform at least one of: generating the first matrix by including one or more message bits of the input sequence and one or more redundancy bits; generating the second matrix by including one or more message bits of the input sequence and one or more redundancy bits; and generating the third matrix by including one or more message bits of the input sequence and one or more redundancy bits.

According to a second aspect, the disclosure relates to an apparatus for staircase polar code decoding a sequence of bits from a sequence of matrices received over a communication channel, wherein each matrix corresponds to an encoded matrix of a sequence of encoded matrices transmitted by another apparatus over the communication channel, wherein the staircase polar code decoding comprises two or more decoding steps. The apparatus is configured to perform a first decoding step of the two or more decoding steps by: propagating logarithmic likelihood ratios, LLR, of a first matrix to obtain a first LLR matrix, wherein the LLR of the first matrix are related to a first encoded matrix of the sequence of encoded matrices; interleaving the first LLR matrix to obtain a first interleaved matrix; prepending the first interleaved matrix to a second matrix to obtain a first prepended matrix, wherein the second matrix is related to a second encoded matrix of the sequence of encoded matrices; decoding each column of the first prepended matrix using a polar code decoding algorithm to obtain a first decoded matrix; and computing an updated second matrix by adding the first decoded matrix to a second LLR matrix comprising LLR received from the communication channel after the transmission of the second encoded matrix.

The apparatus of the second aspect is further configured to perform a second decoding step of the two or more decoding steps by: propagating the LLR of the updated second matrix to obtain a third LLR matrix; interleaving the second LLR matrix to obtain a second interleaved matrix; prepending the second interleaved matrix to a third matrix to obtain a second prepended matrix, wherein the third matrix is related to a third encoded matrix of the sequence of encoded matrices; decoding each column of the second prepended matrix using a polar code decoding algorithm to obtain a second decoded matrix; and computing an updated third matrix by adding the second decoded matrix to a third LLR matrix comprising LLR received from the communication channel after the transmission of the third encoded matrix.

The apparatus of the second aspect provides an improved staircase decoding using polar codes. Further, the interleaver may provide the advantage that the performance of staircase polar decoding can be improved. In particular, the error correction capability of the staircase code can be improved, as large variations in the probability of errors among different codewords can be avoided by selecting the interleaver based on the above considerations.

The apparatus of the second aspect is further configured to interleave the first LLR matrix or the second LLR matrix by: performing a 90° clockwise rotation of the first or second LLR matrix and a column index shift of the bit positions $x_{i,j}$ of each of the rows of the rotated first or second LLR matrix.

With such an interleaver, the performance of the staircase polar decoding can be improved as described above. The interleaver provides a good tradeoff between performance and low complexity.

According to a third aspect, the disclosure relates to a method for staircase polar code encoding an input sequence of message bits into a sequence of matrices, wherein the staircase polar code encoding comprises two or more encoding steps.

The method of the third aspect corresponds to the apparatus of the first aspect. The method of the third aspect may accordingly have implementation forms that correspond to the implementation forms of the apparatus of the first aspect, in particular, with respect to the second encoding step and the third encoding step. The method of the third aspect provides the same advantages as described above for the apparatus of the first aspect.

According to a fourth aspect, the disclosure relates to a method for staircase polar code decoding a sequence of bits from a sequence of matrices received over a communication channel, wherein each matrix corresponds to an encoded matrix of a sequence of encoded matrices transmitted over the communication channel, wherein the staircase polar code decoding comprises two or more decoding steps.

The method of the fourth aspect corresponds to the apparatus of the second aspect. The method of the fourth aspect may accordingly have implementation forms that correspond to the implementation forms of the apparatus of the second aspect.

The method of the fourth aspect provides the same advantages as described above for the apparatus of the second aspect.

According to a fifth aspect, the disclosure relates to a computer program comprising a computer program product for performing the method of the third aspect or the method of the fourth aspect, or any implementation forms thereof.

It has to be noted that all devices, elements, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

BRIEF DESCRIPTION OF DRAWINGS

The above described aspects and implementation forms of the present disclosure will be explained in the following description of specific embodiments in relation to the enclosed drawings, in which:

FIG. 1      illustrates a conventional staircase code.

FIG. 2      shows an exemplary staircase polar code decoding at a decoder not forming part of the claimed invention.

FIG. 3      shows a communication system comprising an encoder and a decoder according to embodiments of the disclosure.

FIG. 4      shows a first step of a staircase polar code encoding performed by an encoder according to an embodiment.

FIG. 5      shows a further step of the staircase polar code encoding performed by the encoder according to the embodiment.

FIG. 6      shows a further step of the staircase polar code encoding performed by the encoder according to the embodiment.

FIG. 7      shows a further step of the staircase polar code encoding performed by the encoder according to the embodiment.

FIG. 8      shows a staircase polar code encoding performed by an encoder according to an embodiment.

FIG. 9      shows interleaving during a staircase polar code decoding with a standard interleaver and with a specific interleaver as, respectively, performed by a decoder according to an embodiment.

FIG. 10     shows interleaving during a staircase polar code decoding with a specific interleaver performed by a decoder according to an embodiment.

FIG. 11     shows a method for staircase polar code encoding according to an embodiment.

FIG. 12     shows a method for staircase polar code decoding according to an embodiment.

## DETAILED DESCRIPTION OF EMBODIMENTS

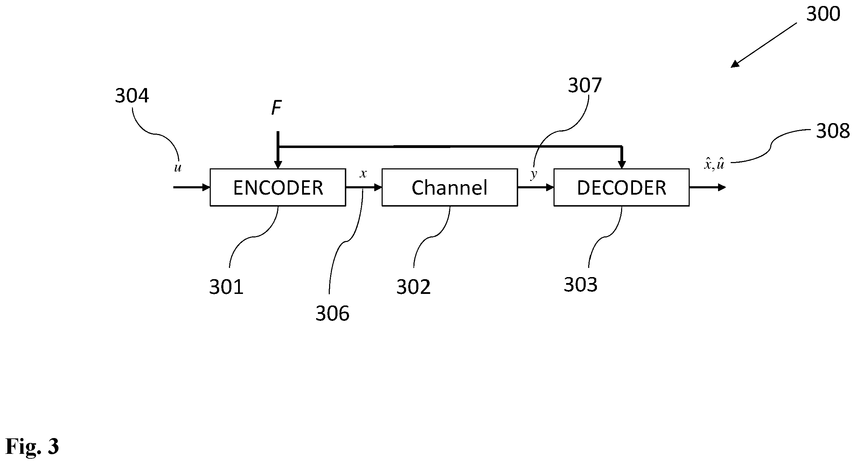

Fig. 3 shows a communication system 300 comprising an encoder 301 (also referred to as apparatus for staircase polar code encoding) and a decoder 303 (also referred to as apparatus for staircase polar code decoding) according to embodiments of the present disclosure. The encoder 301 and the decoder 303 communicate over a communication channel 302, in particular, over a noisy communication channel.

In the communication system 300, data to be transmitted (denoted u) is given to the encoder 301. The data is an input sequence of message bits 304. The encoder 301 produces the codeword (denoted x), which is a sequence of matrices 306 and may contain redundancy. The sequence of matrices 306 is generated by the encoder using a staircase polar code and based on a frozen set F known to encoder 301 and decoder 303. The sequence of matrices 306 is then transmitted over the noisy communication channel 302, which may introduce errors. An output of the channel 302 (denoted $y$), which is a sequence of matrices 307, is received by the decoder 303. Based on the received sequence of matrices 307, the decoder 303 may produce estimates 305 (denoted $\hat{x}$, $\hat{u}$) of the sequence of matrices 306 transmitted by the encoder 301, and the sequence of message bits 304, respectively, and as explained below in more detail.

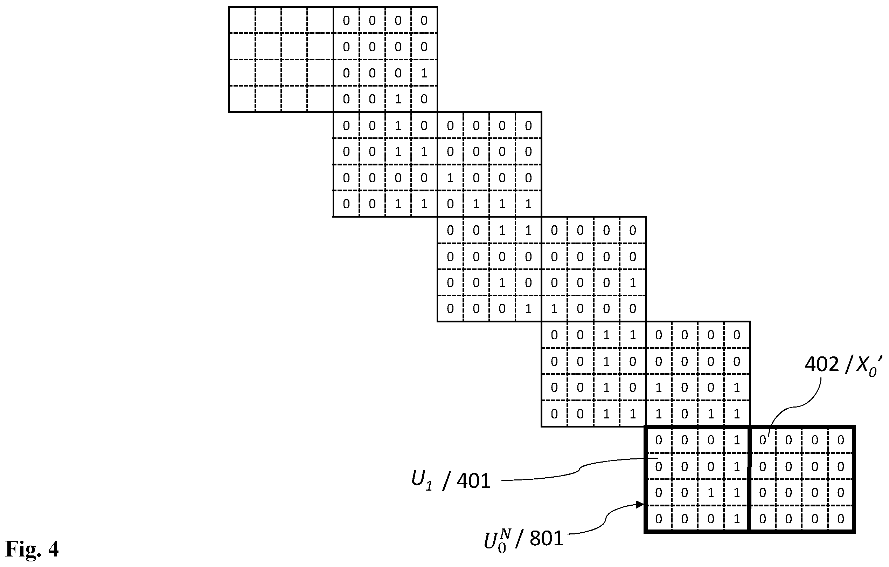

In the following, at first a detailed description of a staircase polar code construction at the encoder 301 is given with reference to the Figs. 4-7. In these figures, matrices are shown in white before encoding and in gray after encoding.

The encoder 301 is configured to perform the staircase polar code encoding. That is, the encoder 301 is configured to encode the input sequence of message bits 304 into the sequence of matrices 306 on the basis of the staircase polar code. The staircase polar code encoding performed by the encoder 301 comprises two or more encoding steps.

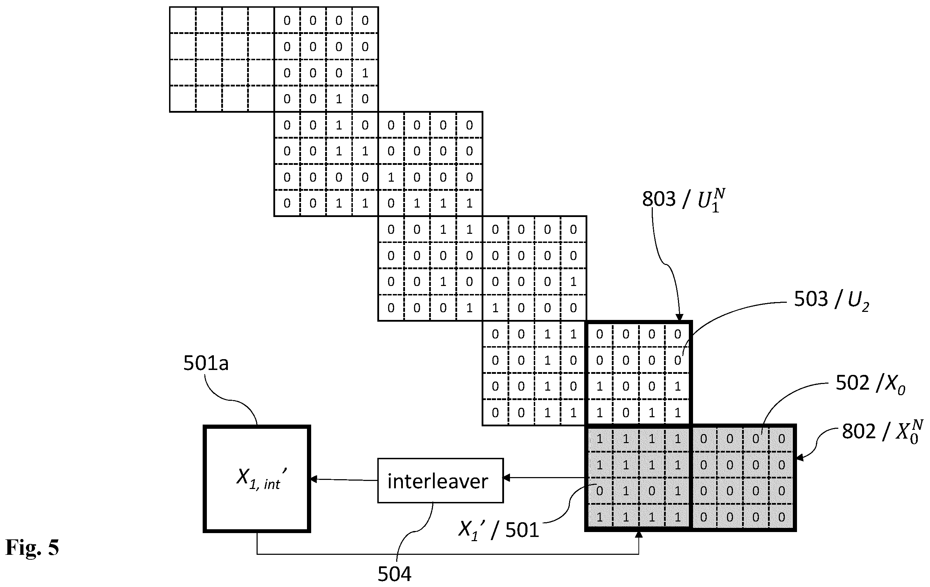

In particular, as shown in Fig. 4 and Fig. 5, the encoder 301 is configured to perform a first encoding step of the two or more encoding steps as follows. The encoder 301 is configured to generate (see Fig. 4) a first matrix 801 (denoted $U_o^N$) having a size MxN, where M=N/2. For example, as shown in the Figs. 4-7, N=8 and M=4. In each row of the first matrix 801, each bit position $x_{i,j}$ of the first matrix 801 for 0≤j<M contains an information bit or a frozen bit depending on a set of frozen bit indices F (the frozen set F mentioned with respect to Fig. 3) of a polar code of length N, where i is a row index and j is a column index.

The bit positions $x_{i,j}$ of the first matrix 801 for 0≤i<M and 0≤j<M form a first sub-matrix 401 (denoted $U_1$) and the bit positions $x_{i,j}$ of the first matrix for 0≤i<M and M≤j<N form a second sub-matrix 402 (denoted $X_o'$).

The encoder 301 is further configured to encode (see Fig. 5) each row of the first matrix 801 using the polar code of length N to obtain a first encoded matrix 802 (denoted $X_o^N$), wherein bit positions $x_{i,j}$ of the first encoded matrix 802 for 0≤i<M and 0≤j<M form a first encoded sub-matrix 501 (denoted $X_1'$) and the bit positions $x_{i,j}$ of the first encoded matrix 802 for 0≤i<M and M≤j<N form a second encoded sub-matrix 502 (denoted $X_0$).

Moreover, the encoder 301 is configured to interleave the first encoded sub-matrix 501 to obtain a first interleaved sub-matrix 501a (denoted $X_{1,int}'$), for instance, using an interleaver 504 as shown in Fig. 5. This concludes the first encoding step performed by the encoder 301.

Afterwards, the encoder 301 is configured to transmit the second encoded sub-matrix 502 (over the channel 302 to the decoder 303), and then to perform a second encoding step of the two or more encoding steps, which is based on the first interleaved sub-matrix 501a, and is described in the following.

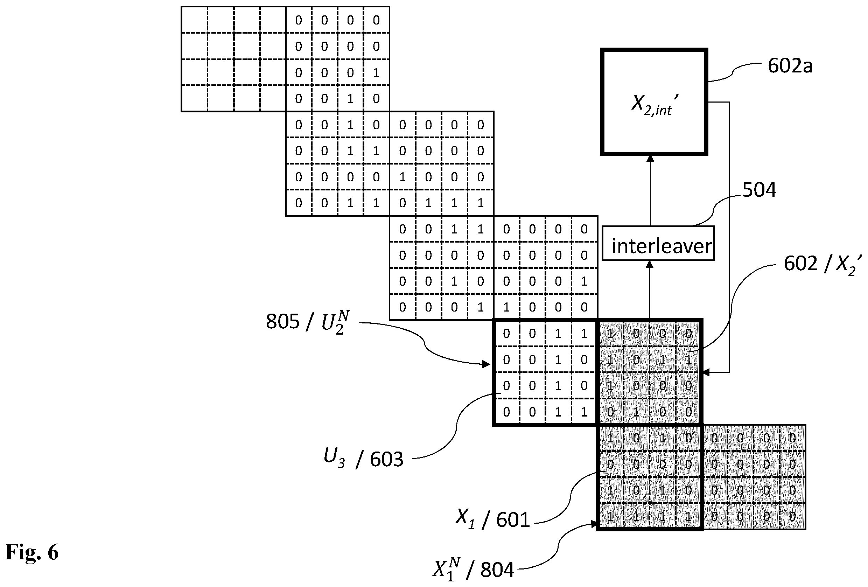

As shown in Fig. 5 and 6, the encoder 301 may be configured to perform the second encoding step as follows. First, the encoder 301 may be configured to generate (see Fig. 5) a second matrix 803 (denoted $U_1^N$) having a size NxM. In each column of the second matrix 803, each bit position $x_{i,j}$ for $0 \leq i < N$ contains an information bit or a frozen bit depending on the set of frozen bit indices F of the polar code of length N. The bit positions $x_{i,j}$ of the second matrix 803 for $0 \leq j < M$ and $0 \leq i < N$ form a third sub-matrix 503 (denoted $U_2$) and the bit positions $x_{i,j}$ for $0 \leq j < M$ and $N \leq i < N$ form a fourth sub-matrix, which is equal to the first interleaved sub-matrix 501a.

Furthermore, the encoder 301 may be configured to encode (see Fig. 6) each column of the second matrix 803 using the polar code of length N to obtain a second encoded matrix 804 (denoted $X_1^N$), wherein bit positions $x_{i,j}$ of the second encoded matrix 804 for $0 \leq j < M$ and $0 \leq i < N$ form a third encoded sub-matrix 602 (denoted $X_2'$) and the bit positions $x_{i,j}$ of the second encoded matrix 804 for $0 \leq j < M$ and $N \leq j < N$ form a fourth encoded sub-matrix 601 (denoted $X_1$). Then, the encoder 301 is configured to interleave the third encoded sub-matrix 602 to obtain a second interleaved sub-matrix 602a (denoted $X_{2,int}'$), for instance, using again the interleaver 504. This concludes the second encoding step performed by the encoder 301.

Afterwards, the encoder 301 is configured to transmit the fourth encoded sub-matrix 601 (over the channel 302 to the decoder 303). The encoder 301 is then further configured to perform a third encoding step based on the second interleaved sub-matrix 602a, as explained in the following.

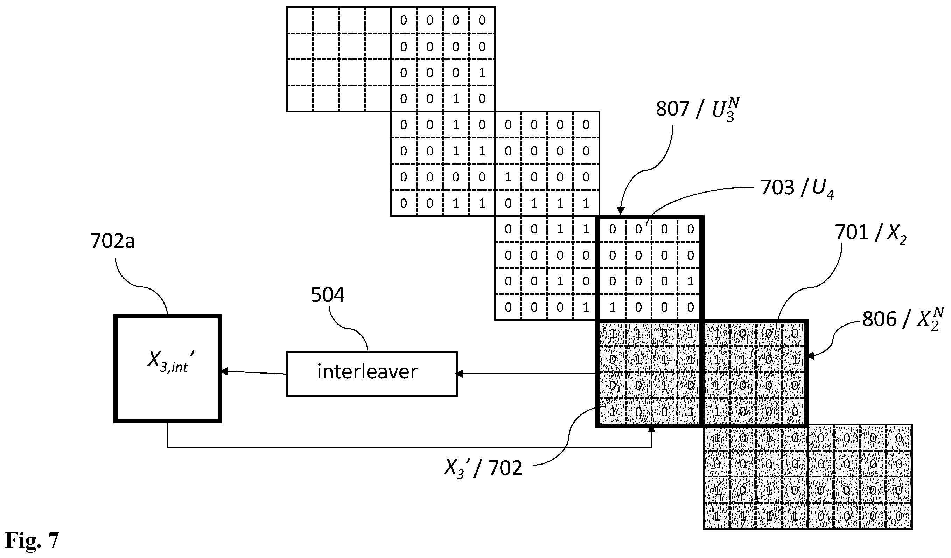

As shown in Fig. 6 and 7, the encoder 301 may be configured to perform the third encoding step as follows. Firstly, the encoder 301 may be configured to generate (see Fig. 6) a third matrix 805 (denoted $U_2^N$) of a size MxN. In each row of the third matrix 805, each bit position $x_{i,j}$ for $0 \leq j < M$ contains an information bit or a frozen bit depending on the set of frozen bit indices F of the polar code of length N. The bit positions $x_{i,j}$ for $0 \leq i < M$ and $0 \leq j < M$ form a fifth sub-matrix 603 (denoted $U_3$) and the bit positions $x_{i,j}$ for $0 \leq i < M$ and $M \leq j < N$ form a sixth sub-matrix equal to the second interleaved sub-matrix 602a.

Afterwards, the encoder 301 may be configured to encode (see Fig. 7) each row of the third matrix 805 using the polar code of length N to obtain a third encoded matrix 806 (denoted $X_2^N$), wherein bit positions $x_{i,j}$ of the third encoded matrix 806 for $0 \leq i < M$ and $0 \leq j < M$ form a fifth encoded sub-matrix 702 (denoted $X_3'$) and the bit positions $x_{i,j}$ of the third encoded matrix 806 for $0 \leq i < M$

and $M \leq j < N$ form a sixth encoded sub-matrix 701 (denoted $X_2$). Then, the encoder 301 may be configured to interleave the fifth encoded sub-matrix 702 to obtain a third interleaved sub-matrix 702a (denoted $X_{3,int}'$), for instance using the interleaver 504, and to transmit the sixth encoded sub-matrix 701 (over the channel 302 to the decoder 304). This concludes the third encoding step performed by the encoder 301.

The encoder 301 may be further configured to perform a fourth encoding step based on the third interleaved sub-matrix 702a, in a similar manner as described above for the second encoding step. Thereby, the encoder 301 may form (see Fig. 7) a fourth matrix 807 (denoted $U_3^N$) of a size NxM, in a similar manner as the second matrix 803 with the third interleaved sub-matrix 702a forming a part of the fourth matrix 807. In this way, the staircase polar code encoding may include further encoding steps performed by the encoder 301.

It can also be derived from the above that the decoder 303 obtains the sequence of matrices 306 after being transmitted over the channel 302, i.e., the decoder 303 obtains the sequence of matrices 307 that results from noise introduced by the noisy channel 302 into the sequence of matrices 306.

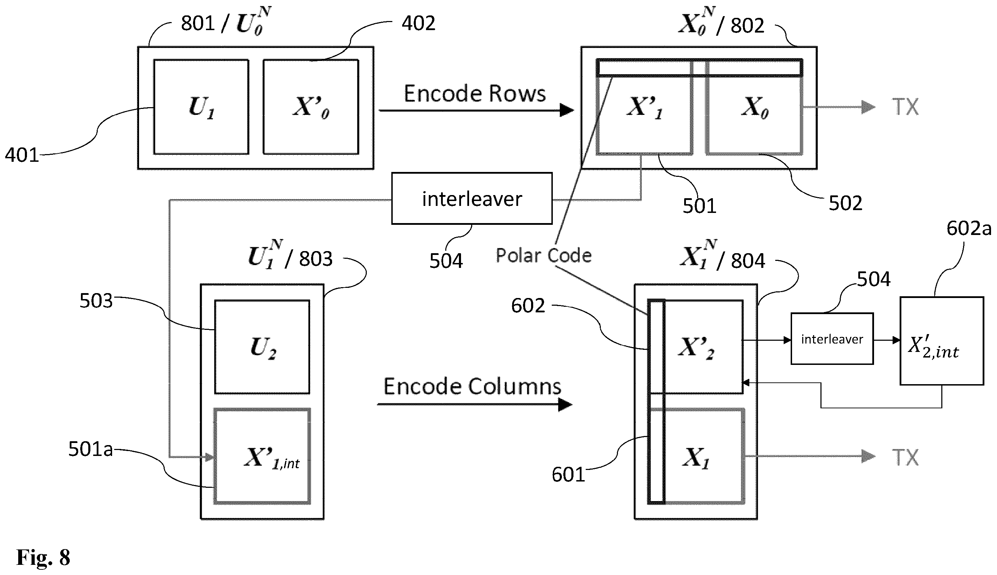

Fig. 8 shows another schematic representation of a staircase polar code encoding as performed by the encoder 301 according to an embodiment of this disclosure. The staircase polar encoding shown in Fig. 8 bases on that shown in Fig. 4-7, in particular, it may be considered an overview over the first two encoding steps performed by the encoder 301.

As already described above, in staircase constructions a part of the information vector (before encoding) of each component codeword is composed of previously encoded or transmitted bits. In the most straightforward staircase construction, the N bit input vector provided to the encoder 301 is composed of a first half, where information and frozen bits are placed, and a second half that is composed of previously encoded bits. Consequently, the specific set of frozen bits used for staircase component polar codes has frozen bits in the N -K least reliable positions among the leftmost N/2 bit positions.

With respect to FIG. 8, the input sequence of message bits 304 may be provided to the encoder 301, and the first matrix 801 (referred to as $U_o^N$) can be defined based thereon. This first matrix 801 is composed of M = N/2 row or column vectors of size N. To initialize the encoding and transmission process, the first matrix 801 can be built such that in every row $0 \leq i < N/2$ each bit position $x_{i,j}$ for $0 \leq j \leq N/2$ (where i is a row index and j is a column index) contains an information bit (e.g. a message bit 304) or a frozen bit according to the set of frozen bits F, while all bit positions $x_{i,j}$ for $j \geq N/2$ may be set to 0. Given the entries at the bit positions $x_{i,j}$ of the first matrix

$U_o^N$ , a first sub-matrix 401 (referred to as $U_1$) can be identified as being composed of all the entries at bit positions $x_{i,j}$, for which $0 \leq j < N/2$, and a second sub-matrix 402 (referred to as $X_0'$ ) can be identified as being composed of all entries at bit positions $x_{i,j}$ for which $N/2 \leq j < N$. Each row of the first matrix $U_o^N$ is then encoded according to a matrix $G^{\otimes n}$ (which represents encoding by using a polar code of length N), resulting in the first encoded matrix 802 (also referred to as $X_o^N$ ). As in the case of the first matrix $U_o^N$ , the leftmost half of the first encoded matrix 802 can be defined as a first encoded sub-matrix 501 (referred to as $X_1'$ ) and a second encoded sub-matrix 502 (referred to as $X_0$) can be defined as comprising the rightmost $N/2 \times N/2$ bit positions $x_{i,j}$. A first frame transmitted by the encoder 301 over the channel 302 to the decoder 303 may be constituted by the second encoded sub-matrix $X_0$, and it is then discarded by the encoder 301.

Afterwards, the first encoded sub-matrix $X_1'$ is interleaved, e.g. using the interleaver 504, in order to obtain a first interleaved sub-matrix 501a (referred to as $X_{1,int}'$ ).

The columns of $X_{1,int}'$ are then appended to a set of column input vectors forming a third sub-matrix 503 (referred to as $U_2$). In particular, a second matrix 803 (referred to as $U_1^N$ ) is generated, wherein the bit positions $x_{i,j}$ of the second matrix 803 for $0 \leq j < M$ and $0 \leq i < N$ form the third sub-matrix 503 and the bit positions $x_{i,j}$ for $0 \leq j < M$ and $N \leq i < N$ form a fourth sub-matrix equal to the first interleaved sub-matrix 501a.

The columns of the second matrix $U_1^N$ are then encoded through $G^{\otimes n}$ (i.e., again using the polar code of length N) resulting in a second encoded matrix 804 (referred to as $U_1^N$ ), within which a third encoded sub-matrix 602 (referred to as $X_2'$ ) can be defined for bit positions $x_{i,j}$ with $0 \leq i < N/2$, and a fourth encoded sub-matrix 601 can be defined (referred to as $X_1$) composed of entries at bit positions $x_{i,j}$ for $N/2 \leq i < N$. The fourth encoded sub-matrix $X_1$, having been encoded by both row-encoding and column-encoding, is then transmitted in a next frame by the encoder 301 over the channel 302 to the decoder 303.

The third encoded sub-matrix $X_2'$ is interleaved to obtain a second interleaved sub-matrix 602a (referred to as $X_{2,int}'$ ), wherein the second interleaved sub-matrix $X_{2,int}'$ composes a part of the third matrix 805 formed for the next encoding step.

As can be understood, the staircase polar code encoding performed by the encoder 301 comprises at least two encoding steps (as just described) or more than two encoding steps, which change repeatedly from row-encoding to column-encoding, and then again from column-encoding to row-encoding.

The interleaving steps described above may be performed by the specific interleaver 504 - as shown in Fig. 8 - selected and applied between the row-encoding and the column-encoding phases.

As an example interleaver, a clockwise-counterclockwise 90-degree rotation may be identified as a standard interleaved referred to as $\Pi_{std}$. For example, given a bit position $x_{i,j}$ in a $N/2 \times N/2$ matrix encoded by rows in a row-encoding phase (e.g., the first encoded sub-matrix 501), for $0 \leq i,j < N/2$, the standard interleaver for row-to-column, i.e. $\Pi_{std}$ ($\Pi_{RtoC}$), applied before the column-encoding phase, may be equivalent to a 90° clockwise rotation given by:

$$x_{col}(j, N/2 - 1 - i) = x_{row}(i,j) \, ,$$

while, in the opposite direction, a matrix encoded by columns in a column-encoding phase (e.g., the third first encoded sub-matrix 602) may be interleaved by the standard interleaver for column-to-row, i.e. $\Pi_{std}(\Pi_{CtoR})$, which may be equivalent to a 90° counterclockwise rotation expressed by

$$x_{row}(N/2 - 1 - j, i) = x_{col}(i,j).$$

Notably, any one-to-one interleaver could be used in the encoding process of the encoder 301. However, specific interleavers 504 that provide better results than the standard interleaver are described in the following. The different interleavers 504 may be used by the encoder 301 according to embodiments of the disclosure.

In particular, the encoder 301 may be configured to interleave the first encoded sub-matrix 501 using an interleaver 504 referred to as $\Pi_{trans\_pol}$ (particularly, $\Pi_{trans\_pol}(\Pi_{RtoC})$, since row-to-column encoding is performed). In an example not forming part of the claimed invention, the interleaving is done by firstly performing a 90° clockwise rotation of the first encoded sub-matrix 501 and then performing a transposition of the rotated first encoded sub-matrix 501. According to the claimed invention, the interleaving is done by performing the 90° clockwise rotation of the first encoded sub-matrix 501 and then a column index shift of the bit positions $x_{i,j}$ of each of the rows of the rotated first encoded sub-matrix.

In an example not forming part of the claimed invention, the encoder 301 may be configured to interleave the first encoded sub-matrix 501 using an interleaver 504 referred to as $\Pi_{rnd\_pol}$ (particularly, $\Pi_{rnd\_pol}$ ($\Pi_{RtoC}$), since row-to-column encoding is performed). The interleaving is done by performing a random permutation of the bit positions $x_{i,j}$ of the first encoded sub-matrix 501.

In an example not forming part of the claimed invention, the encoder 301 may be configured to interleave the first encoded sub-matrix 501 by using an interleaver 504 referred to as $\Pi_{frz\_pol}$ (particularly, $\Pi_{frz\_pol}$ ($\Pi_{RtoC}$), since row-to-column encoding is performed). The interleaving is done by performing a permutation of the bit positions $x_{i,j}$ of the first encoded sub-matrix 501, wherein the permutation is based on a determined decoding method, and wherein the frozen bits are arranged at bit positions $x_{i,j}$ that are related to bit positions having a highest decoding error probability in the decoding method.

The encoder 301 may be further configured to interleave the third encoded sub-matrix 602 using the interleaver 504 referred to as $\Pi_{trans\_pol}$ (particularly, $\Pi_{trans\_pol}(\Pi_{CtoR})$, since column-to-row encoding is performed). The interleaving is done by performing a 90° counterclockwise rotation of the third encoded sub-matrix 602 and then a transposition of the rotated third encoded sub-matrix. Alternatively, the interleaving is done by performing a 90° counterclockwise rotation of the third encoded sub-matrix 602 and then a row index shift of the bit positions $x_{i,j}$ of each of the rows of the rotated third encoded sub-matrix.

Alternatively, the encoder 301 may be configured to interleave the third encoded sub-matrix 602 by using the interleaver 504 referred to as $\Pi_{rnd\_pol}$ (particularly, $\Pi_{rnd\_pol}(\Pi_{CtoR})$, since column-to-row encoding is performed). The interleaving is done by performing a random permutation of the bit positions $x_{i,j}$ of the third encoded sub-matrix 602.

Alternatively, the encoder 301 may be configured to interleave the third encoded sub-matrix 602 by using the interleaver 504 referred to as $\Pi_{frz\_pol}$ (particularly, $\Pi_{frz\_pol}(\Pi_{CtoR})$, since column-to-row encoding is performed). The interleaving is done by performing a permutation of the bit positions $x_{i,j}$ of the third encoded sub-matrix 602, wherein the permutation is based on a determined decoding method, and wherein the frozen bits are arranged at bit positions $x_{i,j}$ that are related to bit positions having a highest decoding error probability in the decoding method.

The encoder 301 may be further configured to interleave the fifth encoded sub-matrix 702 using the interleaver 504 referred to as $\Pi_{trans\_pol}$ (particularly, $\Pi_{trans\_pol}(\Pi_{RtoC})$, since again row-to-column encoding is performed). The interleaving is done by performing a 90° clockwise rotation of the fifth encoded sub-matrix 702 and then a transposition of the rotated fifth encoded sub-matrix. Alternatively, the interleaving is done by performing a 90° clockwise rotation of the fifth encoded sub-matrix 702 and then a column index shift of the bit positions $x_{i,j}$ of each of the rows of the rotated fifth encoded sub-matrix.

Alternatively, the encoder 301 may be configured to interleave the fifth encoded sub-matrix 702 by using the interleaver 504 referred to as $\Pi_{rnd\_pol}$ (particularly, $\Pi_{rnds\_pol}(\Pi_{RtoC})$, since again row-to-column encoding is performed). The interleaving is done by performing a random permutation of the bit positions $x_{i,j}$ of the fifth encoded sub-matrix 702.

Alternatively, the encoder 301 may be configured to interleave the fifth encoded sub-matrix 702 by using the interleaver 504 referred to as $\Pi_{frz\_pol}$ (particularly, $\Pi_{frz\_pol}(\Pi_{RtoC})$, since again row-to-column encoding is performed). The interleaving is done by performing a permutation of the bit positions $x_{i,j}$ of the fifth encoded sub-matrix 702, wherein the permutation is based on a determined decoding method, and wherein the frozen bits are arranged at the bit positions $x_{i,j}$ related to bit positions having the highest decoding error probability in the decoding method.

Notably, in this disclosure, an information bit may be a message bit of the input sequence or a redundancy bit, which is calculated based on the message bits of the input sequence.

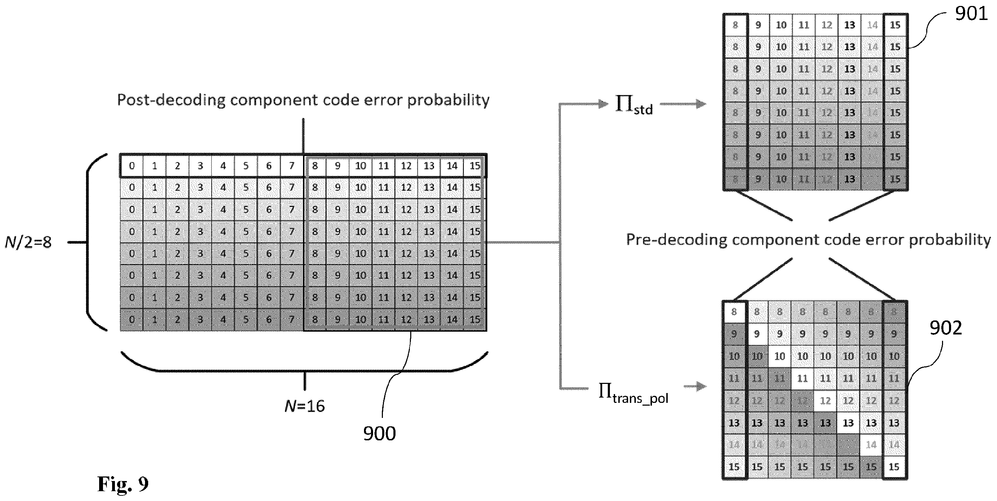

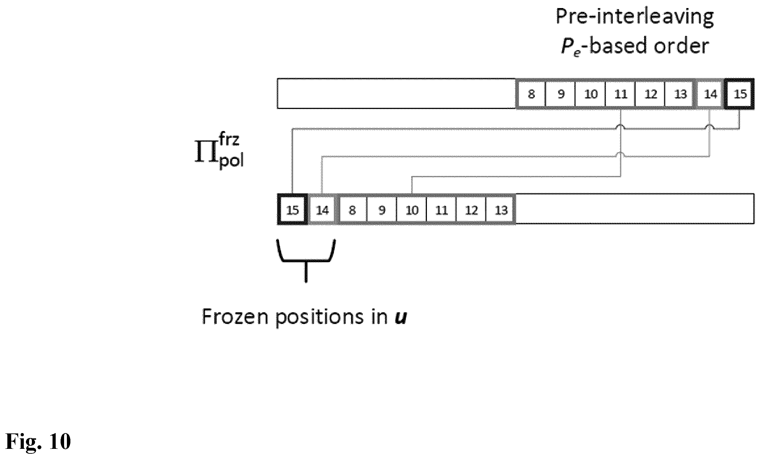

FIG. 9 and 10 show schematic representations of interleaving data at the decoder side according to embodiments.

Generally, as far as decoding is concerned, the decoder 303 (or apparatus for staircase polar code decoding) is configured to decode a sequence of bits from a sequence of matrices 307 received over the communication channel 302, wherein each matrix corresponds to an encoded matrix of a sequence of encoded matrices 306 transmitted by another apparatus (e.g., the encoder 301 described above) over the communication channel 302. The staircase polar code decoding comprises two or more decoding steps.

The decoder 303 is configured to perform a first decoding step of the two or more decoding steps as follows. The decoder 303 is configured to propagate LLR of a first matrix to obtain a first LLR matrix 900, wherein the LLR of the first matrix are related to a first encoded matrix of the sequence of encoded matrices. Then, the decoder 303 is configured to interleave the first LLR matrix 900 (using, e.g., an interleaver 504 as described above) to obtain a first interleaved matrix 902, and afterwards to prepend the first interleaved matrix 902 to a second matrix to obtain a first prepended matrix. The second matrix is related to a second encoded matrix of the sequence of encoded matrices. The decoder 303 is further configured to decode each column of the first prepended matrix using a polar code decoding algorithm to obtain a first decoded matrix. Then, the decoder 303 is configured to compute an updated second matrix by adding the first decoded matrix to a second LLR matrix comprising LLR received from the communication channel 302 after the transmission of the second encoded matrix. This concludes the first decoding step.

The decoder 303 is further configured to perform a second decoding step of the two or more decoding steps as follows. The decoder 303 is configured to propagate the LLR of the updated second matrix to obtain a third LLR matrix. Then, the decoder 303 is configured to interleave the second LLR matrix to obtain a second interleaved matrix, and afterwards to prepend the second interleaved matrix to a third matrix to obtain a second prepended matrix. The third matrix is related to a third encoded matrix of the sequence of encoded matrices. The decoder 303 is further configured to decode each column of the second prepended matrix using a polar code decoding algorithm to obtain a second decoded matrix. Then the decoder 303 is configured to compute an updated third matrix by adding the second decoded matrix to a third LLR matrix comprising LLR received from the communication channel after the transmission of the third encoded matrix.

As already mentioned above, staircase constructions with algebraic component codes rely on the fact that all bits in the component codewords have the same probability of error. However, the standard interleaver $\Pi_{std}$ (when being used at the encoder 301 as described above) does not take into account that serial decoding algorithms used at the decoder 303, like those based on SC, return estimated vectors with unevenly distributed probability of errors. Since the estimation of bit i relies on the correct estimation of previous bits j < i, its probability of error is approximately:

$$P_e^i \lessapprox P_{1e}^i + \frac{1}{2} \sum_{j=0}^{i-1} P_{1e}^j$$

where $P_{1e}^j$ is the probability of making the first decoding mistake, when estimating the bit j, as determined during the design of the frozen set F.

However, the standard interleaver $\Pi_{std}$, after a decoding phase at the decoder 303 (e.g., row-decoding) distributes the error probabilities so that for the following decoding phase (column decoding) each component codeword is composed of bits with the same probability.

Therefore, some specific interleavers 504 defined in this disclosure cater specifically to the particularities of polar codes. As with the standard interleaver $\Pi_{std}$, each bit of the interleaved half-codeword is taken from a different non-interleaved half-codeword. However, the specific interleavers 504 proposed by this disclosure ensure that each bit has a different $P_e$, and that the cumulative $P_e$ is constant in each interleaved codeword. Within an interleaved half-codeword, different permutations of the interleaved bits are possible to guarantee a constant cumulative $P_e$. The three interleavers 504 referred to as $\Pi_{trans\_pol}$ (see Fig. 9), $\Pi_{frz\_pol}$ (see Fig. 10), and $\Pi_{rnd\_pol}$ - as already explained above with respect to the encoder 301 - are specifically proposed.

Fig. 9 compares interleaving at the decoder 303 using the standard interleaver $\Pi_{std}$ and the interleaver referred to as $\Pi_{trans\_pol}$. In the non-claimed case that the standard interleaver is applied to the first LLR matrix 900 an interleaved matrix 901 is obtained. If the interleaver $\Pi_{trans\_pol}$ is applied to the first LLR matrix 900, the first interleaved matrix 902 is obtained as described above. In the example of Fig. 9, N=16 and M=N/2=8. It can be seen in FIG. 9 that - as mentioned above - the standard interleaver $\Pi_{std}$ distributes the error probabilities so that each component codeword is composed of bits with the same probability (wherein error probabilities are labelled 0-15).

To address this, the decoder 303 is configured to interleave the first LLR matrix 900 (or the second LLR matrix) using the interleaver 504 referred to as $\Pi_{trans\_pol}$. In an example not falling under the scope of the claimed invention, the interleaving is done by performing a 90° clockwise rotation of the first or second LLR matrix and a transposition of the rotated first or second LLR matrix. According to the claimed invention, the interleaving is done by performing a 90° clockwise rotation of the first or second LLR matrix and then a column index shift of the bit positions $x_{i,j}$ of each of the rows of the rotated first or second LLR matrix.

That is, the interleaver $\Pi_{trans\_pol}$ shown in Fig. 9 performs a transposition of the rotated matrix.

This interleaver 504 can be expressed as:

$$x_\Pi(i,j) = x\big((i-j) \mod (N/2), j\big)$$

It can be seen in FIG. 9 that this achieves that each bit of an interleaved component codeword has a different error probability, and that the cumulative error probability is constant in each interleaved codeword.

In a non-claimed example, the decoder 303 may be configured to interleave the first LLR matrix 900 or the second LLR matrix using the interleaver 504 referred to as $\Pi_{frz\_pol}$. The interleaving is done by performing a permutation of the bit positions $x_{i,j}$ of the first encoded sub-matrix, wherein the permutation is such that frozen bits are arranged at bit positions of LLR having a highest decoding error probability.

The interleaver referred to as $\Pi_{frz\_pol}$ exploits the fact that each channel LLR $\lambda_i^{(n)}$ corresponding to a code bit $x_i$ directly contributes to the estimation of some of the source bits $u_j$ where $j \leq i$. Assuming that all $u_j$ with j < i have been correctly estimated, $u_i$ will be estimated incorrectly if $\lambda_i^{(n)}$ has the wrong sign and an enough large magnitude. The probability of this occurrence increases with the post-decoding $P_e$ depicted in Fig. 10. However, it is not possible to incorrectly estimate a frozen bit. LLRs with high $P_e$ can, thus, be neutralized by interleaving them onto frozen positions. After N-K positions have been filled, the remaining positions are assigned to the K bits with the lowest $P_e$, in ascending order, again to minimize the possibility of incorrect estimation. An example is shown in Fig. 10.

In a non-claimed example, the decoder 303 may be configured to interleave the first LLR matrix 900 or the second LLR matrix using the interleaver 504 referred to as $\Pi_{rnd\_pol}$. The interleaving is done by performing a random permutation of the bit positions $x_{i,j}$ of the first or second LLR matrix. The interleaver 504 referred to as $\Pi_{rnd\_pol}$ performs a random permutation of the bits assigned to the interleaved half-codeword.

In the following, another concept of the present disclosure is described, in particular, the proposal of cyclic-redundancy-check (CRC) insertion. The staircase decoding algorithm, similar to other sliding-window based soft decoding approaches, decodes all component codes in the window at each iteration (see e.g., Fig. 2). However, if it was possible to identify decoding instances that are not necessary, the number of component decoding could be reduced. This may have a positive impact on decoding latency and on decoder implementation complexity, as long as any error-correction performance degradation is within acceptable parameters.

To this end, in the encoder 301 according to an embodiment of the disclosure, a message bit of the input sequence or a redundancy bit calculated based on the message bits 304 of the input sequence. For instance, the encoder 301 may be to generate the first matrix 801 by including one or more message bits 304 of the input sequence and one or more redundancy bits. Additionally or alternatively, the encoder 301 may be configured to generate the second matrix 803 by including one or more message bits 304 of the input sequence and one or more redundancy bits. Additionally or alternatively, the encoder 301 may be configured to generate the third matrix 805 by including one or more message bits 304 of the input sequence and one or more redundancy bits.

According to an embodiment, each component code source vector may be concatenated with a CRC, that encodes only the K - N/2 information bits that do not belong to the respective matrix.

In the following, the decoding of a component code composed of N/2 bits of a matrix $X_i^0$ and of N/2 bits of $X_{i-1}$ is considered. The component decoding process returns a set of soft values relative to an estimated source vector $\hat{u}$, constructed of estimated bits belonging to $\hat{U}_i$ and $\hat{X}'^{i-1}$. If the CRC passes, it is assumed that the relative row of $\hat{U}_i$ is correctly estimated, while no assumptions on $\hat{X}_{i-1}^0$ are made. Track can be kept of which half component codes in each frame have passed the CRC. In the following iteration, they are not decoded at all when used as $X^0$, while their $\Lambda$ (compare description of the decoder in the summary part) is not updated when used as $X$. To ensure soft value propagation throughout the decoding window, the decoding of a component codeword is forced in case it was skipped at the previous iteration. Soft encoding is used to obtain the $\Lambda^0$ of skipped component codes.

The presence of a CRC can be beneficial to component decoders as well. The concatenation of a polar code with a CRC has been successful in substantially improving the performance of SCL when the CRC is used to select the decoder output among the $L$ available.

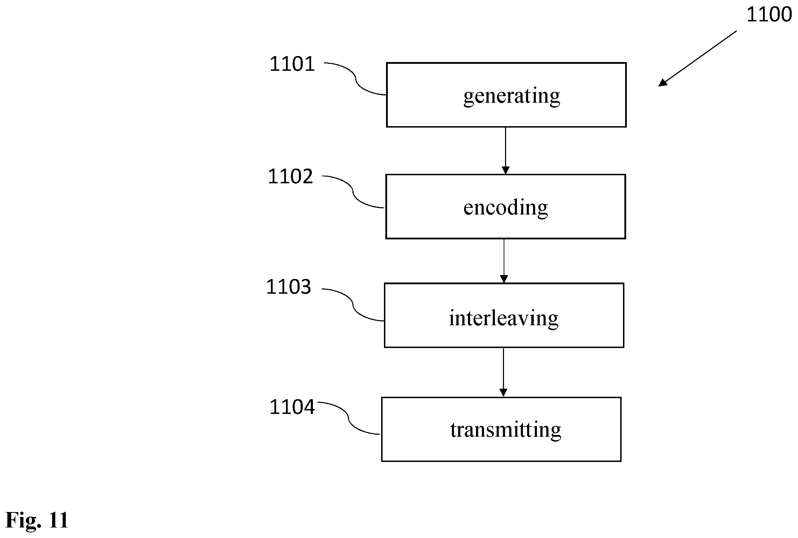

FIG. 11 shows a schematic representation of a method for encoding data according to an embodiment.

The method 1100 for staircase polar code comprises encoding an input sequence of message bits into a sequence of matrices, wherein the staircase polar code encoding comprises two or more encoding steps. The method comprises a first encoding step of the two or more encoding steps. The first encoding step comprises generating, at 1101, a first matrix having a size MxN, where M=N/2, wherein, in each row of the first matrix, each bit position $x_{i,j}$ of the first matrix for $0 \leq j < M$ contains an information bit or a frozen bit depending on a set of frozen bit indices F of a polar code of length N, where i is a row index and j is a column index, and wherein the bit positions $x_{i,j}$ of the first matrix for $0 \leq i < M$ and $0 \leq j < M$ form a first sub-matrix and the bit positions $x_{i,j}$ of the first matrix for $0 \leq i < M$ and $M \leq j < N$ form a second sub-matrix. Further, the first encoding step comprises encoding, at 1102, each row of the first matrix using the polar code of length N to obtain a first encoded matrix, wherein bit positions $x_{i,j}$ of the first encoded matrix for $0 \leq i < M$ and $0 \leq j < M$ form a first encoded sub-matrix and the bit positions $x_{i,j}$ of the first encoded matrix for $0 \leq i < M$ and $M \leq j < N$ form a second encoded sub-matrix. The first encoding step further comprises interleaving, at 1103, the first encoded sub-matrix to obtain a first interleaved sub-matrix, and transmitting, at 1104, the second encoded sub-matrix. The method then further comprises a second encoding step (not shown) of the two or more encoding steps that is based on the first interleaved sub-matrix.

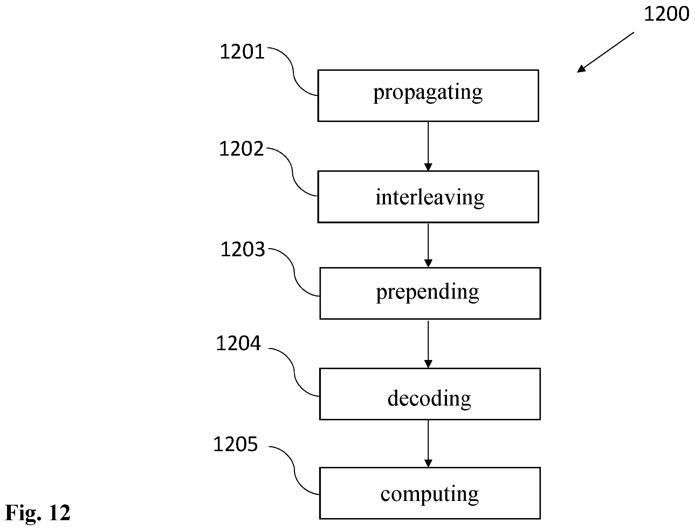

FIG. 12 shows a schematic representation of a method 1200 for decoding data according to an embodiment.

The method 1200 for staircase polar code comprises decoding a sequence of bits from a sequence of matrices received over a communication channel 302, wherein each matrix corresponds to an encoded matrix of a sequence of encoded matrices transmitted over the communication channel, wherein the staircase polar code decoding comprises two or more decoding steps. The method comprises a first decoding step of the two or more decoding steps that comprises propagating, at 1201, logarithmic likelihood ratios, LLR, of a first matrix to obtain a first LLR matrix, wherein the LLR of the first matrix are related to a first encoded matrix of the sequence of encoded matrices. The first decoding step further comprises interleaving, at 1202, the first LLR matrix to obtain a first interleaved matrix, and prepending, at 1203, the first interleaved matrix to a second matrix to obtain a first prepended matrix. The second matrix is related to a second encoded matrix of the sequence of encoded matrices. The first decoding step further comprises decoding, at 1204, each column of the first prepended matrix using a polar code decoding algorithm to obtain a first decoded matrix, and computing, at 1205, an updated second matrix by adding the first decoded matrix to a second LLR matrix comprising LLR received from the communication channel after the transmission of the second encoded matrix.

The present disclosure has been described in conjunction with various embodiments as examples as well as implementations. However, other variations can be understood and effected by those persons skilled in the art and practicing the claimed subject matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. An apparatus (301) for staircase polar code encoding an input sequence of message bits (304) into a sequence of matrices (306), wherein the staircase polar code encoding comprises two or more encoding steps, and wherein the apparatus (301) is configured to perform a first encoding step of the two or more encoding steps by:

   generating a first matrix (801) having a size MxN, where M=N/2, wherein, in each row of the first matrix (801), each bit position $x_{i,j}$ of the first matrix (801) for $0 \leq j < M$ contains an information bit or a frozen bit depending on a set of frozen bit indices F of a polar code of length N, where i is a row index and j is a column index, and wherein the bit positions $x_{i,j}$ of the first matrix (801) for $0 \leq i < M$ and $0 \leq j < M$ form a first sub-matrix (401) and the bit positions $x_{i,j}$ of the first matrix (801) for $0 \leq i < M$ and $M \leq j < N$ form a second sub-matrix (402);
   encoding each row of the first matrix (801) using the polar code of length N to obtain a first encoded matrix (802), wherein bit positions $x_{i,j}$ of the first encoded matrix (802) for $0 \leq i < M$ and $0 \leq j < M$ form a first encoded sub-matrix (501) and the bit positions $x_{i,j}$ of the first encoded matrix (802) for $0 \leq i < M$ and $M \leq j < N$ form a second encoded sub-matrix (502);
   interleaving the first encoded sub-matrix (501) to obtain a first interleaved sub-matrix (501a) by performing a 90° clockwise rotation of the first encoded sub-matrix (501) and a column index shift of the bit positions $x_{i,j}$ of each of the rows of the rotated first encoded sub-matrix; and

   transmitting the second encoded sub-matrix (502), and
   wherein the apparatus (301) is further configured to perform a second encoding step of the two or more encoding steps based on the first interleaved sub-matrix (501a) by:

   generating a second matrix (803) having a size NxM, wherein, in each column of the second matrix (803), each bit position xi,j for $0 \leq i < N$ contains an information bit or a frozen bit depending on the set of frozen bit indices F of the polar code of length N, and wherein the bit positions xi,j of the second matrix (803) for $0 \leq j < M$ and $0 \leq i < N$ form a third sub-matrix (503) and the bit positions xi,j for $0 \leq j < M$ and $N \leq i < N$ form a fourth sub-matrix, which is equal to the first interleaved sub-matrix (501a);
   encoding each column of the second matrix (803) using the polar code of length N to obtain a second encoded matrix (804), wherein bit positions $x_{i,j}$ of the second encoded matrix (804) for $0 \leq j < M$ and $0 \leq i < N$ form a third encoded sub-matrix (602) and the bit positions xi,j of the second encoded matrix (804) for $0 \leq j < M$ and $N \leq j < N$ form a fourth encoded sub-matrix (601);
   interleaving the third encoded sub-matrix (602) to obtain a second interleaved sub-matrix (602a); and
   transmitting the fourth encoded sub-matrix (601), and
   wherein the apparatus (301) is further configured to perform a third encoding step based on the second interleaved sub-matrix (602a).

2. The apparatus (301) of claim 1, configured to interleave the third encoded sub-matrix (602) by:

   performing a 90° counterclockwise rotation of the third encoded sub-matrix (602) and a transposition of the rotated third encoded sub-matrix, or
   performing a 90° counterclockwise rotation of the third encoded sub-matrix (602) and a row index shift of the bit positions $x_{i,j}$ of each of the rows of the rotated third encoded sub-matrix.

3. The apparatus (301) of claim 1, configured to interleave the third encoded sub-matrix (602) by performing a random permutation of the bit positions $x_{i,j}$ of the third encoded sub-matrix (602).

4. The apparatus (301) of claim 1, configured to interleave the third encoded sub-matrix (602) by performing a permutation of the bit positions $x_{i,j}$ of the third encoded sub-matrix (602), wherein the permutation is based on a determined decoding method, and wherein the frozen bits are arranged at bit positions $x_{i,j}$ that are related to bit positions having a highest decoding error probability in the decoding method.

5. The apparatus (301) of any one of the claims 1 to 4, wherein the apparatus (301) is configured to perform the third encoding step by:

generating a third matrix (805) of a size MxN , wherein, in each row of the third matrix (805), each bit position $x_{i,j}$ for $0 \leq j <$ M contains an information bit or a frozen bit depending on the set of frozen bit indices F of the polar code of length N, and wherein the bit positions $x_{i,j}$ for $0 \leq i < M$ and $0 \leq j <$ M form a fifth sub-matrix (603) and the bit positions $x_{i,j}$ for $0 \leq i < M$ and $M \leq j < N$ form a sixth sub-matrix (602) equal to the second interleaved sub-matrix (602a);
encoding each row of the third matrix (805) using the polar code of length N to obtain a third encoded matrix (806), wherein bit positions $x_{i,j}$ of the third encoded matrix (806) for $0 \leq i < M$ and $0 \leq j <$ M form a fifth encoded sub-matrix (702) and the bit positions $x_{i,j}$ of the third encoded matrix (806) for $0 \leq i < M$ and $M \leq j < N$ form a sixth encoded sub-matrix (701);
interleaving the fifth encoded sub-matrix (702) to obtain a third interleaved sub-matrix (702a); and
transmitting the sixth encoded sub-matrix (701), and
wherein the apparatus (301) is further configured to perform a fourth encoding step based on the third interleaved sub-matrix (702a).

6. The apparatus (301) of claim 5, configured to interleave the fifth encoded sub-matrix (702) by:

performing a 90° clockwise rotation of the fifth encoded sub-matrix (702) and a transposition of the rotated fifth encoded sub-matrix, or
performing a 90° clockwise rotation of the fifth encoded sub-matrix (702) and a column index shift of the bit positions $x_{i,j}$ of each of the rows of the rotated fifth encoded sub-matrix.

7. The apparatus (301) of claim 6, configured to interleave the fifth encoded sub-matrix (702) by performing a random permutation of the bit positions $x_{i,j}$ of the fifth encoded sub-matrix (702).

8. An apparatus (303) for staircase polar code decoding a sequence of bits from a sequence of matrices (307) received over a communication channel (302), wherein each matrix (307) corresponds to an encoded matrix (306) of a sequence of encoded matrices (306) transmitted by another apparatus (301) over the communication channel (302), wherein the staircase polar code decoding comprises two or more decoding steps, and wherein the apparatus (303) is configured to perform a first decoding step of the two or more decoding steps by:

propagating logarithmic likelihood ratios, LLR, of a first matrix to obtain a first LLR matrix (900), wherein the LLR of the first matrix are related to a first encoded matrix of the sequence of encoded matrices (306);
interleaving the first LLR matrix (900) to obtain a first interleaved matrix (902);
prepending the first interleaved matrix (902) to a second matrix to obtain a first prepended matrix, wherein the second matrix is related to a second encoded matrix of the sequence of encoded matrices (306);
decoding each column of the first prepended matrix using a polar code decoding algorithm to obtain a first decoded matrix;
computing an updated second matrix by adding the first decoded matrix to a second LLR matrix comprising LLR received from the communication channel after the transmission of the second encoded matrix;
wherein the apparatus (303) is further configured to perform a second decoding step of the two or more decoding steps by:

propagating the LLR of the updated second matrix to obtain a third LLR matrix;
interleaving the second LLR matrix to obtain a second interleaved matrix;
prepending the second interleaved matrix to a third matrix to obtain a second prepended matrix, wherein the third matrix is related to a third encoded matrix of the sequence of encoded matrices;
decoding each column of the second prepended matrix using a polar code decoding algorithm to obtain a second decoded matrix; and
computing an updated third matrix by adding the second decoded matrix to a third LLR matrix comprising LLR received from the communication channel after the transmission of the third encoded matrix; and
wherein the apparatus (303) is configured to interleave the first LLR matrix or the second LLR matrix by performing a 90° clockwise rotation of the first or second LLR matrix and a column index shift of the bit positions $x_{i,j}$ of each of the rows of the rotated first or second LLR matrix.

9. A method (1100) for staircase polar code encoding an input sequence of message bits (304) into a sequence of matrices (306), wherein the staircase polar code encoding comprises two or more encoding steps, and wherein the method comprises a first encoding step of the two or more encoding steps that comprises:

generating (1101) a first matrix (801) having a size MxN, where M=N/2, wherein, in each row of the first matrix (801), each bit position $x_{i,j}$ of the first matrix (801) for 0≤j<M contains an information bit or a frozen bit depending on a set of frozen bit indices F of a polar code of length N, where i is a row index and j is a column index, and wherein the bit positions $x_{i,j}$ of the first matrix (801) for 0≤i<M and 0≤j<M form a first sub-matrix (401) and the bit positions $x_{i,j}$ of the first matrix for 0≤i<M and M≤j<N form a second sub-matrix (402);

encoding (1102) each row of the first matrix (801) using the polar code of length N to obtain a first encoded matrix (802), wherein bit positions $x_{i,j}$ of the first encoded matrix (802) for 0≤i<M and 0≤j<M form a first encoded sub-matrix (501) and the bit positions $x_{i,j}$ of the first encoded matrix for 0≤i<M and M≤j<N form a second encoded sub-matrix (502);

interleaving (1103) the first encoded sub-matrix (501) to obtain a first interleaved sub-matrix (501a) by performing a 90° clockwise rotation of the first encoded sub-matrix (501) and a column index shift of the bit positions $x_{i,j}$ of each of the rows of the rotated first encoded sub-matrix; and

transmitting (1104) the second encoded sub-matrix (402), and

wherein the method (1100) further comprises a second encoding step of the two or more encoding steps that is based on the first interleaved sub-matrix (501a) by:

generating a second matrix (803) having a size NxM, wherein, in each column of the second matrix (803), each bit position xi,j for 0≤i<N contains an information bit or a frozen bit depending on the set of frozen bit indices F of the polar code of length N, and wherein the bit positions xi,j of the second matrix (803) for 0≤j<M and 0≤i<N form a third sub-matrix (503) and the bit positions xi,j for 0≤j<M and N ≤i<N form a fourth sub-matrix, which is equal to the first interleaved sub-matrix (501a);

encoding each column of the second matrix (803) using the polar code of length N to obtain a second encoded matrix (804), wherein bit positions $x_{i,j}$ of the second encoded matrix (804) for 0≤j<M and 0≤i<N form a third encoded sub-matrix (602) and the bit positions xi,j of the second encoded matrix (804) for 0≤j<M and N ≤j<N form a fourth encoded sub-matrix (601); interleaving the third encoded sub-matrix (602) to obtain a second interleaved sub-matrix (602a); and transmitting the fourth encoded sub-matrix (601), and the method further comprises performing a third encoding step based on the second interleaved sub-matrix (602a).

10. A method (1200) for staircase polar code decoding a sequence of bits from a sequence of matrices (307) received over a communication channel (302), wherein each matrix (307) corresponds to an encoded matrix (306) of a sequence of encoded matrices (306) transmitted over the communication channel (302), wherein the staircase polar code decoding comprises two or more decoding steps, and wherein the method (1200) comprises a first decoding step of the two or more decoding steps that comprises:

propagating (1201) logarithmic likelihood ratios, LLR, of a first matrix to obtain a first LLR matrix (900), wherein the LLR of the first matrix are related to a first encoded matrix of the sequence of encoded matrices (306);

interleaving (1202) the first LLR matrix (900) to obtain a first interleaved matrix (902);

prepending (1203) the first interleaved matrix (902) to a second matrix to obtain a first prepended matrix, wherein the second matrix is related to a second encoded matrix of the sequence of encoded matrices (306);

decoding (1204) each column of the first prepended matrix using a polar code decoding algorithm to obtain a first decoded matrix;

computing (1205) an updated second matrix by adding the first decoded matrix to a second LLR matrix comprising LLR received from the communication channel after the transmission of the second encoded matrix;

performing a second decoding step of the two or more decoding steps by:

propagating the LLR of the updated second matrix to obtain a third LLR matrix; interleaving the second LLR matrix to obtain a second interleaved matrix; prepending the second interleaved matrix to a third matrix to obtain a second prepended matrix, wherein the third matrix is related to a third encoded matrix of the sequence of encoded matrices; decoding each column of the second prepended matrix using a polar code decoding algorithm to obtain a second decoded matrix; and

computing an updated third matrix by adding the second decoded matrix to a third LLR matrix comprising LLR received from the communication channel after the transmission of the third encoded matrix;

wherein the method further comprises interleaving the first LLR matrix or the second LLR matrix by performing a 90° clockwise rotation of the first or second LLR matrix and a column index shift of the bit positions $x_{i,j}$ of each of the rows of the rotated first or second LLR matrix.

11. A computer program comprising a computer program product for performing the method (1100, 1200) of claim 9 or 10.

## Patentansprüche

1. Vorrichtung (301) zur Codierung von Treppenpolarcodes einer Eingabesequenz von Nachrichtenbits (304) in eine Sequenz von Matrizen (306), wobei die Codierung von Treppenpolarcodes zwei oder mehr Codierungsschritte umfasst, und wobei die Vorrichtung (301) dazu konfiguriert ist, einen ersten Codierungsschritt der zwei oder mehr Codierungsschritte durch Folgendes durchzuführen:

Generieren einer ersten Matrix (801), die eine Größe M x N aufweist, wobei M = N/2, wobei, in jeder Zeile der ersten Matrix (801), jede Bitposition $x_{i,j}$ der ersten Matrix (801) für $0 \leq j < M$ ein Informationsbit oder ein Frozen-Bit in Abhängigkeit von einem Satz von Frozen-Bit-Indizes F eines Polarcodes der Länge N enthält, wobei i ein Zeilenindex ist und j ein Spaltenindex ist, und wobei die Bitpositionen $x_{i,j}$ der ersten Matrix (801) für $0 \leq i < M$ und $0 \leq j < M$ eine erste Teilmatrix (401) ausbilden und die Bitpositionen $x_{i,j}$ der ersten Matrix (801) für $0 \leq i < M$ und $M \leq j < N$ eine zweite Teilmatrix (402) ausbilden;
Codieren jeder Zeile der ersten Matrix (801) unter Verwendung des Polarcodes der Länge N, um eine erste codierte Matrix (802) zu erlangen, wobei die Bitpositionen $x_{i,j}$ der ersten codierten Matrix (802) für $0 \leq i < M$ und $0 \leq j < M$ eine erste codierte Teilmatrix (501) ausbilden und die Bitpositionen $x_{i,j}$ der ersten codierten Matrix (802) für $0 \leq i < M$ und $M \leq j < N$ eine zweite codierte Teilmatrix (502) ausbilden;
Verschachteln der ersten codierten Teilmatrix (501), um eine erste verschachtelte Teilmatrix (501a) zu erlangen, indem eine 90°-Drehung der ersten codierten Teilmatrix (501) im Uhrzeigersinn und eine Spaltenindexverschiebung der Bitpositionen $x_{i,j}$ jeder der Zeilen der gedrehten ersten codierten Teilmatrix durchgeführt wird; und
Übertragen der zweiten codierten Teilmatrix (502), und
wobei die Vorrichtung (301) ferner dazu konfiguriert ist, einen zweiten Codierungsschritt der zwei oder mehr Codierungsschritte basierend auf der ersten verschachtelten Teilmatrix (501a) durch Folgendes durchzuführen:

Generieren einer zweiten Matrix (803), die eine Größe N x M aufweist, wobei, in jeder Spalte der zweiten Matrix (803), jede Bitposition $x_{i,j}$ für $0 \leq i < N$ ein Informationsbit oder ein Frozen-Bit in Abhängigkeit von dem Satz von Frozen-Bit-Indizes F des Polarcodes der Länge N enthält, und wobei die Bitpositionen $x_{i,j}$ der zweiten Matrix (803) für $0 \leq j < M$ und $0 \leq i < N$ eine dritte Teilmatrix (503) aufweisen und die Bitpositionen $x_{i,j}$ für $0 \leq j < M$ und $N \leq i < N$ eine vierte Teilmatrix aufweisen, welche gleich der ersten verschachtelten Teilmatrix (501a) ist;
Codieren jeder Spalte der zweiten Matrix (803) unter Verwendung des Polarcodes der Länge N, um eine zweite codierte Matrix (804) zu erlangen, wobei Bitpositionen $x_{i,j}$ der zweiten codierten Matrix (804) für $0 \leq j < M$ und $0 \leq i < N$ eine dritte codierte Teilmatrix (602) ausbilden und die Bitpositionen $x_{i,j}$ der zweiten codierten Matrix (804) für $0 \leq j < M$ und $N \leq j < N$ eine vierte codierte Teilmatrix (601) ausbilden;
Verschachteln der dritten codierten Teilmatrix (602), um eine zweite verschachtelte Teilmatrix (602a) zu erlangen; und
Übertragen der vierten codierten Teilmatrix (601), und
wobei die Vorrichtung (301) ferner dazu konfiguriert ist, einen dritten Codierungsschritt basierend auf der zweiten verschachtelten Teilmatrix (602a) durchzuführen.

2. Vorrichtung (301) nach Anspruch 1, die dazu konfiguriert ist, die dritte codierte Teilmatrix (602) durch Folgendes zu verschachteln:

Durchführen einer 90°-Drehung der dritten codierten Teilmatrix (602) entgegen dem Uhrzeigersinn und einer Transposition der gedrehten dritten codierten Teilmatrix, oder
Durchführen einer 90°-Drehung der dritten codierten Teilmatrix (602) entgegen dem Uhrzeigersinn und einer Zeilenindexverschiebung der Bitpositionen $x_{i,j}$ jeder der Zeilen der gedrehten dritten codierten Teilmatrix.

3. Vorrichtung (301) nach Anspruch 1, die dazu konfiguriert ist, die dritte codierte Teilmatrix (602) durch Durchführen einer zufälligen Permutation der Bitpositionen $x_{i,j}$ der dritten codierten Teilmatrix (602) zu verschachteln.

4. Vorrichtung (301) nach Anspruch 1, die dazu konfiguriert ist, die dritte codierte Teilmatrix (602) durch Durchführen einer Permutation der Bitpositionen $x_{i,j}$ der dritten codierten Teilmatrix (602) zu verschachteln, wobei die Permutation auf einem bestimmten Decodierungsverfahren basiert und wobei die Frozen-Bits an Bitpositionen $x_{i,j}$ angeordnet sind, die sich auf Bitpositionen beziehen, die in dem Decodierungsverfahren die höchste Decodierungsfehlerwahrscheinlichkeit aufweisen.

5. Vorrichtung (301) nach einem der Ansprüche 1 bis 4, wobei die Vorrichtung (301) dazu konfiguriert ist, den dritten Codierungsschritt durch Folgendes durchzuführen:

   Generieren einer dritten Matrix (805) einer Größe N x M, wobei, in jeder Zeile der dritten Matrix (805), jede Bitposition $x_{i,j}$ für $0 \le j < M$ ein Informationsbit oder ein Frozen-Bit in Abhängigkeit von dem Satz von Fozen-Bit-Indizes F des Polarcodes der Länge N enthält, und wobei die Bitpositionen $x_{i,j}$ für $0 \le i < M$ und $0 \le j < M$ eine fünfte Teilmatrix (603) ausbilden und die Bitpositionen $x_{i,j}$ für $0 \le i < M$ und $M \le j < N$ eine sechste Teilmatrix (602) gleich der zweiten verschachtelten Teilmatrix (602a) ausbilden;
   Codieren jeder Zeile der dritten Matrix (805) unter Verwendung des Polarcodes der Länge N, um eine dritte codierte Matrix (806) zu erlangen, wobei Bitpositionen $x_{i,j}$ der dritten codierten Matrix (806) für $0 \le i < M$ and $0 \le j < M$ eine fünfte codierte Teilmatrix (702) ausbilden und die Bitpositionen $x_{i,j}$ der dritten codierten Matrix (806) für $0 \le i < M$ und $M \le j < N$ eine sechste codierte Teilmatrix (701) ausbilden;
   Verschachteln der fünften codierten Teilmatrix (702), um eine dritte verschachtelte Teilmatrix (702a) zu erlangen; und
   Übertragen der sechsten codierten Teilmatrix (701), und
   wobei die Vorrichtung (301) ferner dazu konfiguriert ist, einen vierten Codierungsschritt basierend auf der dritten verschachtelten Teilmatrix (702a) durchzuführen.

6. Vorrichtung (301) nach Anspruch 5, die dazu konfiguriert ist, die fünfte codierte Teilmatrix (702) durch Folgendes zu verschachteln:

   Durchführen einer 90°-Drehung der fünften codierten Teilmatrix (702) im Uhrzeigersinn und einer Transposition der gedrehten fünften codierten Teilmatrix, oder
Durchführen einer 90°-Drehung der fünften codierten Teilmatrix (702) im Uhrzeigersinn und einer Spaltenindexverschiebung der Bitpositionen $x_{i,j}$ jeder der Zeilen der gedrehten fünften codierten Teilmatrix.

7. Vorrichtung (301) nach Anspruch 6, die dazu konfiguriert ist, die fünfte codierte Teilmatrix (702) durch Durchführen einer zufälligen Permutation der Bitpositionen $x_{i,j}$ der fünften codierten Teilmatrix (702) zu verschachteln.

8. Vorrichtung (303) zur Decodierung von Treppenpolarcodes einer Sequenz von Bits aus einer Sequenz von Matrizen (307), die über einen Kommunikationskanal (302) empfangen wird, wobei jede Matrix (307) einer codierten Matrix (306) einer Sequenz von codierten Matrizen (306) entspricht, die durch eine andere Vorrichtung (301) über den Kommunikationskanal (302) übertragen wird, wobei die Decodierung von Treppenpolarcodes zwei oder mehr Decodierungsschritte umfasst, und wobei die Vorrichtung (303) dazu konfiguriert ist, einen ersten Decodierungsschritt der zwei oder mehr Decodierungsschritte durch Folgendes durchzuführen:

   Propagieren der logarithmischen Wahrscheinlichkeitsverhältnisse, LLR, einer ersten Matrix, um eine erste LLR-Matrix (900) zu erlangen, wobei sich die LLR der ersten Matrix auf eine erste codierte Matrix der Sequenz von codierten Matrizen (306) beziehen;
   Verschachteln der ersten LLR-Matrix (900), um eine erste verschachtelte Matrix (902) zu erlangen;
   Voranstellen der ersten verschachtelten Matrix (902) einer zweiten Matrix, um eine erste vorangestellte Matrix zu erlangen, wobei sich die zweite Matrix auf eine zweite codierte Matrix der Sequenz von codierten Matrizen (306) bezieht;
   Decodieren jeder Spalte der ersten vorangestellten Matrix unter Verwendung eines Decodierungsalgorithmus von Polarcodes, um eine erste decodierte Matrix zu erlangen;
   Berechnen einer aktualisierten zweiten Matrix durch Addieren der ersten decodierten Matrix mit einer zweiten LLR-Matrix, umfassend LLR, die nach der Übertragung der zweiten codierten Matrix von dem Kommunikationskanal empfangen wurde;
   wobei die Vorrichtung (303) ferner dazu konfiguriert ist, einen zweiten Decodierungsschritt der zwei oder mehr Decodierungsschritte durch Folgendes durchzuführen:

Propagieren der LLR der aktualisierten zweiten Matrix, um eine dritte LLR-Matrix zu erlangen;

Verschachteln der zweiten LLR-Matrix, um eine zweite verschachtelte Matrix zu erlangen;

Voranstellen der zweiten verschachtelten Matrix einer dritten Matrix, um eine zweite vorangestellte Matrix zu erlangen, wobei sich die dritte Matrix auf eine dritte codierte Matrix der Sequenz von codierten Matrizen bezieht;

Decodieren jeder Spalte der zweiten vorangestellten Matrix unter Verwendung eines Decodierungsalgorithmus von Polarcodes, um eine zweite decodierte Matrix zu erlangen; und

Berechnen einer aktualisierten dritten Matrix durch Addieren der zweiten decodierten Matrix mit einer dritten LLR-Matrix, umfassend LLR, die nach der Übertragung der dritten codierten Matrix aus dem Kommunikationskanal empfangen wurden; und

wobei die Vorrichtung (303) dazu konfiguriert ist, die erste LLR-Matrix oder die zweite LLR-Matrix durch Durchführen einer 90°-Drehung der ersten oder der zweiten LLR-Matrix im Uhrzeigersinn und einer Spaltenindexverschiebung der Bitpositionen $x_{i,j}$ jeder der Zeilen der gedrehten ersten oder zweiten LLR-Matrix zu verschachteln.

9. Verfahren (1100) zur Codierung von Treppenpolarcodes einer Eingabesequenz von Nachrichtenbits (304) in eine Sequenz von Matrizen (306), wobei die Codierung von Treppenpolarcodes zwei oder mehr Codierungsschritte umfasst, und wobei das Verfahren einen ersten Codierungsschritt der zwei oder mehr Codierungsschritte umfasst, der Folgendes umfasst:

Generieren (1101) einer ersten Matrix (801), die eine Größe M x N aufweist, wobei M = N/2, wobei, in jeder Zeile der ersten Matrix (801), jede Bitposition $x_{i,j}$ der ersten Matrix (801) für $0 \leq j < M$ ein Informationsbit oder ein Frozen-Bit in Abhängigkeit von einem Satz von Frozen-Bit-Indizes F eines Polarcodes der Länge N enthält, wobei i ein Zeilenindex ist und j ein Spaltenindex ist, und wobei die Bitpositionen $x_{i,j}$ der ersten Matrix (801) für $0 \leq i < M$ und $0 \leq j < M$ eine erste Teilmatrix (401) ausbilden und die Bitpositionen $x_{i,j}$ der ersten Matrix für $0 \leq i < M$ und $M \leq j < N$ eine zweite Teilmatrix (402) ausbilden;

Codieren (1102) jeder Zeile der ersten Matrix (801) unter Verwendung des Polarcodes der Länge N, um eine erste codierte Matrix (802) zu erlangen, wobei die Bitpositionen $x_{i,j}$ der ersten codierten Matrix (802) für $0 \leq i < M$ und $0 \leq j < M$ eine erste codierte Teilmatrix (501) ausbilden und die Bitpositionen $x_{i,j}$ der ersten codierten Matrix für $0 \leq i < M$ und $M \leq j < N$ eine zweite codierte Teilmatrix (502) ausbilden;

Verschachteln (1103) der ersten codierten Teilmatrix (501), um eine erste verschachtelte Teilmatrix (501a) zu erlangen, indem eine 90°-Drehung der ersten codierten Teilmatrix (501) im Uhrzeigersinn und eine Spaltenindexverschiebung der Bitpositionen $x_{i,j}$ jeder der Zeilen der gedrehten ersten codierten Teilmatrix durchgeführt wird; und

Übertragen (1104) der zweiten codierten Teilmatrix (402), und wobei das Verfahren (1100) ferner einen zweiten Codierungsschritt der zwei oder mehr Codierungsschritte, der auf der ersten verschachtelten Teilmatrix (501a) basiert, durch Folgendes umfasst:

Generieren einer zweiten Matrix (803), die eine Größe N x M aufweist, wobei, in jeder Spalte der zweiten Matrix (803), jede Bitposition $x_{i,j}$ für $0 \leq i < N$ ein Informationsbit oder ein Frozen-Bit in Abhängigkeit von dem Satz von Frozen-Bit-Indizes F des Polarcodes der Länge N enthält, und wobei die Bitpositionen $x_{i,j}$ der zweiten Matrix (803) für $0 \leq j < M$ und $0 \leq i < N$ eine dritte Teilmatrix (503) aufweisen und die Bitpositionen $x_{i,j}$ für $0 \leq j < M$ und $N \leq i < N$ eine vierte Teilmatrix aufweisen, welche gleich der ersten verschachtelten Teilmatrix (501a) ist;

Codieren jeder Spalte der zweiten Matrix (803) unter Verwendung des Polarcodes der Länge N, um eine zweite codierte Matrix (804) zu erlangen, wobei Bitpositionen $x_{i,j}$ der zweiten codierten Matrix (804) für $0 \leq j < M$ und $0 \leq i < N$ eine dritte codierte Teilmatrix (602) ausbilden und die Bitpositionen $x_{i,j}$ der zweiten codierten Matrix (804) für $0 \leq j < M$ und $N \leq j < N$ eine vierte codierte Teilmatrix (601) ausbilden;

Verschachteln der dritten codierten Teilmatrix (602), um eine zweite verschachtelte Teilmatrix (602a) zu erlangen; und Übertragen der vierten codierten Teilmatrix (601), und

das Verfahren ferner Durchführen eines dritten Codierungsschritts basierend auf der zweiten verschachtelten Teilmatrix (602a) umfasst.

10. Verfahren (1200) zur Decodierung von Treppenpolarcodes einer Sequenz von Bits aus einer Sequenz von Matrizen (307), die über einen Kommunikationskanal (302) empfangen wird, wobei jede Matrix (307) einer codierten Matrix (306) einer Sequenz von codierten Matrizen (306) entspricht, die über den Kommunikationskanal (302) übertragen wird, wobei die Decodierung von Treppenpolarcodes zwei oder mehr Decodierungsschritte umfasst, und wobei das Verfahren (1200) einen ersten Decodierungsschritt der zwei oder mehr Decodierungsschritte umfasst, der Folgendes umfasst:

Propagieren (1201) der logarithmischen Wahrscheinlichkeitsverhältnisse, LLR, einer ersten Matrix, um eine erste LLR-Matrix (900) zu erlangen, wobei sich die LLR der ersten Matrix auf eine erste codierte Matrix der Sequenz von codierten Matrizen (306) beziehen;

Verschachteln (1202) der ersten LLR-Matrix (900), um eine erste verschachtelte Matrix (902) zu erlangen;

Voranstellen (1203) der ersten verschachtelten Matrix (902) einer zweiten Matrix, um eine erste vorangestellte Matrix zu erlangen, wobei sich die zweite Matrix auf eine zweite codierte Matrix der Sequenz von codierten Matrizen (306) bezieht;

Decodieren (1204) jeder Spalte der ersten vorangestellten Matrix unter Verwendung eines Decodierungsalgorithmus von Polarcodes, um eine erste decodierte Matrix zu erlangen;

Berechnen (1205) einer aktualisierten zweiten Matrix durch Addieren der ersten decodierten Matrix mit einer zweiten LLR-Matrix, umfassend LLR, die nach der Übertragung der zweiten codierten Matrix von dem Kommunikationskanal empfangen wurden;

Durchführen eines zweiten Decodierungsschritts der zwei oder mehr Decodierungsschritte durch:

Propagieren der LLR der aktualisierten zweiten Matrix, um eine dritte LLR-Matrix zu erlangen;

Verschachteln der zweiten LLR-Matrix, um eine zweite verschachtelte Matrix zu erlangen;

Voranstellen der zweiten verschachtelten Matrix einer dritten Matrix, um eine zweite vorangestellte Matrix zu erlangen, wobei sich die dritte Matrix auf eine dritte codierte Matrix der Sequenz von codierten Matrizen bezieht;

Decodieren jeder Spalte der zweiten vorangestellten Matrix unter Verwendung eines Decodierungsalgorithmus von Polarcodes, um eine zweite decodierte Matrix zu erlangen; und

Berechnen einer aktualisierten dritten Matrix durch Addieren der zweiten decodierten Matrix mit einer dritten LLR-Matrix, umfassend LLR, die nach der Übertragung der dritten codierten Matrix aus dem Kommunikationskanal empfangen wurden;

wobei das Verfahren ferner Verschachteln der ersten LLR-Matrix oder der zweiten LLR-Matrix durch Durchführen einer 90°-Drehung der ersten oder der zweiten LLR-Matrix im Uhrzeigersinn und einer Spaltenindexverschiebung der Bitpositionen $x_{i,j}$ jeder der Zeilen der gedrehten ersten oder zweiten LLR-Matrix umfasst.

**11.** Computerprogramm, umfassend ein Computerprogrammprodukt zum Durchführen des Verfahrens (1100, 1200) nach Anspruch 9 oder 10.

## Revendications

**1.** Appareil (301) pour coder par code polaire en escalier une séquence d'entrée de bits de message (304) dans une séquence de matrices (306), dans lequel le codage par code polaire en escalier comprend deux ou plusieurs étapes de codage, et dans lequel l'appareil (301) est configuré pour réaliser une première étape de codage des deux ou plusieurs étapes de codage par :

la génération d'une première matrice (801) ayant une taille MxN, où M=N/2, dans lequel, dans chaque ligne de la première matrice (801), chaque position de bit $x_{i,j}$ de la première matrice (801) pour $0 \leq j < M$ contient un bit d'information ou un bit gelé en fonction d'un ensemble d'indices de bits gelés F d'un code polaire de longueur N, où i est un indice de ligne et j est un indice de colonne, et dans lequel les positions de bits $x_{i,j}$ de la première matrice (801) pour $0 \leq i < M$ et $0 \leq j < M$ forment une première sous-matrice (401) et les positions de bits $x_{i,j}$ de la première matrice (801) pour $0 \leq i < M$ et $M \leq j < N$ forment une deuxième sous-matrice (402) ;

le codage de chaque ligne de la première matrice (801) à l'aide du code polaire de longueur N pour obtenir une première matrice codée (802), dans lequel les positions de bits $x_{i,j}$ de la première matrice codée (802) pour $0 \leq i < M$ et $0 \leq j < M$ forment une première sous-matrice codée (501) et les positions de bits $x_{i,j}$ de la première matrice codée (802) pour $0 \leq i < M$ et $M \leq j < N$ forment une deuxième sous-matrice codée (502) ;

l'entrelacement de la première sous-matrice codée (501) pour obtenir une première sous-matrice entrelacée (501a) en réalisant une rotation de 90° dans le sens des aiguilles d'une montre de la première sous-matrice codée (501) et un décalage d'indice de colonne des positions de bits $x_{i,j}$ de chacune des lignes de la première sous-matrice codée tournée ; et

la transmission de la deuxième sous-matrice codée (502), et

dans lequel l'appareil (301) est également configuré pour réaliser une seconde étape de codage des deux ou plusieurs étapes de codage sur la base de la première sous-matrice entrelacée (501a) par :

la génération d'une deuxième matrice (803) ayant une taille NxM, dans lequel, dans chaque colonne de la deuxième matrice (803), chaque position de bit xi,j pour $0 \leq i < N$ contient un bit d'information ou un bit gelé en fonction de l'ensemble d'indices de bits gelés F du code polaire de longueur N, et dans lequel les positions de bits xi,j de la deuxième matrice (803) pour $0 \leq j < M$ et $0 \leq i < N$ forment une troisième sous-matrice (503) et les positions de bits xi,j pour $0 \leq j < M$ et $N \leq i < N$ forment une quatrième sous-matrice, qui est égale à la première sous-matrice entrelacée (501a) ;

le codage de chaque colonne de la deuxième matrice (803) à l'aide du code polaire de longueur N pour obtenir une deuxième matrice codée (804), dans lequel les positions de bits xi,j de la deuxième matrice codée (804) pour $0 \leq j < M$ et $0 \leq i < N$ forment une troisième sous-matrice codée (602) et les positions de bits xi,j de la deuxième matrice codée (804) pour $0 \leq j < M$ et $N \leq j < N$ forment une quatrième sous-matrice codée (601) ;

l'entrelacement de la troisième sous-matrice codée (602) pour obtenir une deuxième sous-matrice entrelacée (602a) ; et

la transmission de la quatrième sous-matrice codée (601), et

dans lequel l'appareil (301) est également configuré pour réaliser une troisième étape de codage sur la base de la deuxième sous-matrice entrelacée (602a).

2. Appareil (301) selon la revendication 1, configuré pour entrelacer la troisième sous-matrice codée (602) par :

la réalisation d'une rotation de 90° dans le sens inverse des aiguilles d'une montre de la troisième sous-matrice codée (602) et d'une transposition de la troisième sous-matrice codée tournée, ou

la réalisation d'une rotation de 90° dans le sens inverse des aiguilles d'une montre de la troisième sous-matrice codée (602) et d'un décalage d'indice de ligne des positions de bits $x_{i,j}$ de chacune des lignes de la troisième sous-matrice codée tournée.

3. Appareil (301) selon la revendication 1, configuré pour entrelacer la troisième sous-matrice codée (602) en réalisant une permutation aléatoire des positions de bits $x_{i,j}$ de la troisième sous-matrice codée (602).

4. Appareil (301) selon la revendication 1, configuré pour entrelacer la troisième sous-matrice codée (602) en réalisant une permutation des positions de bits $x_{i,j}$ de la troisième sous-matrice codée (602), dans lequel la permutation est basée sur un procédé de décodage déterminé, et dans lequel les bits gelés sont agencés à des positions de bits $x_{i,j}$ qui sont liées à des positions de bits ayant une probabilité d'erreur de décodage la plus élevée dans le procédé de décodage.

5. Appareil (301) selon l'une quelconque des revendications 1 à 4, dans lequel l'appareil (301) est configuré pour réaliser la troisième étape de codage par :

la génération d'une troisième matrice (805) d'une taille MxN, dans lequel, dans chaque ligne de la troisième matrice (805), chaque position de bit $x_{i,j}$ pour $0 \leq j < M$ contient un bit d'information ou un bit gelé en fonction de l'ensemble d'indices de bits gelés F du code polaire de longueur N, et dans lequel les positions de bits $x_{i,j}$ pour $0 \leq i < M$ et $0 \leq j < M$ forment une cinquième sous-matrice (603) et les positions de bits $x_{i,j}$ pour $0 \leq i < M$ et $M \leq j < N$ forment une sixième sous-matrice (602) égale à la deuxième sous-matrice entrelacée (602a) ;

le codage de chaque ligne de la troisième matrice (805) à l'aide du code polaire de longueur N pour obtenir une troisième matrice codée (806), dans lequel les positions de bits $x_{i,j}$ de la troisième matrice codée (806) pour $0 \leq i < M$ et $0 \leq j < M$ forment une cinquième sous-matrice codée (702) et les positions de bits $x_{i,j}$ de la troisième matrice codée (806) pour $0 \leq i < M$ et $M \leq j < N$ forment une sixième sous-matrice codée (701) ;

l'entrelacement de la cinquième sous-matrice codée (702) pour obtenir une troisième sous-matrice entrelacée (702a) ; et

la transmission de la sixième sous-matrice codée (701), et

dans lequel l'appareil (301) est également configuré pour réaliser une quatrième étape de codage sur la base de la troisième sous-matrice entrelacée (702a).

6. Appareil (301) selon la revendication 5, configuré pour entrelacer la cinquième sous-matrice codée (702) par :

la réalisation d'une rotation de 90° dans le sens des aiguilles d'une montre de la cinquième sous-matrice codée (702) et d'une transposition de la cinquième sous-matrice codée tournée, ou la réalisation d'une rotation de 90° dans le sens des aiguilles d'une montre de la cinquième sous-matrice codée (702) et d'un décalage d'indice de colonne des positions de bits $x_{i,j}$ de chacune des lignes de la cinquième sous-matrice codée tournée.

7. Appareil (301) selon la revendication 6, configuré pour entrelacer la cinquième sous-matrice codée (702) en réalisant une permutation aléatoire des positions de bits $x_{i,j}$ de la cinquième sous-matrice codée (702).

8. Appareil (303) de décodage de code polaire en escalier d'une séquence de bits à partir d'une séquence de matrices (307) reçues sur un canal de communication (302), dans lequel chaque matrice (307) correspond à une matrice codée (306) d'une séquence de matrices codées (306) transmise par un autre appareil (301) sur le canal de communication (302), dans lequel le décodage de code polaire en escalier comprend deux ou plusieurs étapes de décodage, et dans lequel l'appareil (303) est configuré pour réaliser une première étape de décodage des deux ou plusieurs étapes de décodage par :

la propagation de rapports de vraisemblance logarithmiques, LLR, d'une première matrice pour obtenir une première matrice LLR (900), dans lequel les LLR de la première matrice sont liés à une première matrice codée de la séquence de matrices codées (306) ;
l'entrelacement de la première matrice LLR (900) pour obtenir une première matrice entrelacée (902) ;
le préfixage de la première matrice entrelacée (902) à une deuxième matrice pour obtenir une première matrice préfixée, dans lequel la deuxième matrice est liée à une deuxième matrice codée de la séquence de matrices codées (306) ;
le décodage de chaque colonne de la première matrice préfixée à l'aide d'un algorithme de décodage de code polaire pour obtenir une première matrice décodée ;
le calcul d'une deuxième matrice mise à jour en ajoutant la première matrice décodée à une deuxième matrice LLR comprenant le LLR reçu en provenance du canal de communication après la transmission de la deuxième matrice codée ;
dans lequel l'appareil (303) est également configuré pour réaliser une seconde étape de décodage des deux ou plusieurs étapes de décodage par :

la propagation du LLR de la deuxième matrice mise à jour pour obtenir une troisième matrice LLR ;
l'entrelacement de la deuxième matrice LLR pour obtenir une deuxième matrice entrelacée ;
le préfixage de la deuxième matrice entrelacée à une troisième matrice pour obtenir une deuxième matrice préfixée, dans lequel la troisième matrice est liée à une troisième matrice codée de la séquence de matrices codées ;
le décodage de chaque colonne de la deuxième matrice préfixée à l'aide d'un algorithme de décodage de code polaire pour obtenir une deuxième matrice décodée ; et
le calcul d'une troisième matrice mise à jour en ajoutant la deuxième matrice décodée à une troisième matrice LLR comprenant le LLR reçu en provenance du canal de communication après la transmission de la troisième matrice codée ; et
dans lequel l'appareil (303) est configuré pour entrelacer la première matrice LLR ou la deuxième matrice LLR en réalisant une rotation de 90° dans le sens des aiguilles d'une montre de la première ou de la deuxième matrice LLR et un décalage d'indice de colonne des positions de bits $x_{i,j}$ de chacune des lignes de la première ou de la deuxième matrice LLR tournée.

9. Procédé (1100) de codage par code polaire en escalier d'une séquence d'entrée de bits de message (304) dans une séquence de matrices (306), dans lequel le codage par code polaire en escalier comprend deux ou plusieurs étapes de codage, et dans lequel le procédé comprend une première étape de codage des deux ou plusieurs étapes de codage qui comprend :

la génération (1101) d'une première matrice (801) ayant une taille MxN, où M=N/2, dans lequel, dans chaque ligne de la première matrice (801), chaque position de bit $x_{i,j}$ de la première matrice (801) pour $0 \leq j < M$ contient un bit d'information ou un bit gelé en fonction d'un ensemble d'indices de bits gelés F d'un code polaire de longueur N, où i est un indice de ligne et j est un indice de colonne, et dans lequel les positions de bits $x_{i,j}$ de la première matrice (801) pour $0 \leq i < M$ et $0 \leq j < M$ forment une première sous-matrice (401) et les positions de bits $x_{i,j}$ de la première matrice pour $0 \leq i < M$ et $M \leq j < N$ forment une deuxième sous-matrice (402) ;
le codage (1102) de chaque ligne de la première matrice (801) à l'aide du code polaire de longueur N pour obtenir une première matrice codée (802), dans lequel les positions de bits $x_{i,j}$ de la première matrice codée (802) pour $0 \leq i < M$ et $0 \leq j < M$ forment une première sous-matrice codée (501) et les positions de bits $x_{i,j}$ de la première matrice codée pour $0 \leq i M$ et $M \leq j < N$ forment une deuxième sous-matrice codée (502) ;

l'entrelacement (1103) de la première sous-matrice codée (501) pour obtenir une première sous-matrice entrelacée (501a) en réalisant une rotation de 90° dans le sens des aiguilles d'une montre de la première sous-matrice codée (501) et un décalage d'indice de colonne des positions de bits $x_{i,j}$ de chacune des lignes de la première sous-matrice codée tournée ; et

la transmission (1104) de la deuxième sous-matrice codée (402), et

dans lequel le procédé (1100) comprend également une seconde étape de codage des deux ou plusieurs étapes de codage qui est basée sur la première sous-matrice entrelacée (501a) par :

la génération d'une deuxième matrice (803) ayant une taille NxM, dans lequel, dans chaque colonne de la deuxième matrice (803), chaque position de bit xi,j pour $0 \leq i < N$ contient un bit d'information ou un bit gelé en fonction de l'ensemble d'indices de bits gelés F du code polaire de longueur N, et dans lequel les positions de bits xi,j de la deuxième matrice (803) pour $0 \leq j < M$ et $0 \leq i < N$ forment une troisième sous-matrice (503) et les positions de bits xi,j pour $0 \leq j < M$ et $N \leq i < N$ forment une quatrième sous-matrice, qui est égale à la première sous-matrice entrelacée (501a) ;

le codage de chaque colonne de la deuxième matrice (803) à l'aide du code polaire de longueur N pour obtenir une deuxième matrice codée (804), dans lequel les positions de bits xi,j de la deuxième matrice codée (804) pour $0 \leq j < M$ et $0 \leq i < N$ forment une troisième sous-matrice codée (602) et les positions de bits xi,j de la deuxième matrice codée (804) pour $0 \leq j < M$ et $N \leq j < N$ forment une quatrième sous-matrice codée (601) ;

l'entrelacement de la troisième sous-matrice codée (602) pour obtenir une deuxième sous-matrice entrelacée (602a) ; et

la transmission de la quatrième sous-matrice codée (601), et

le procédé comprend également la réalisation d'une troisième étape de codage sur la base de la deuxième sous-matrice entrelacée (602a).

10. Procédé (1200) de décodage de code polaire en escalier d'une séquence de bits à partir d'une séquence de matrices (307) reçues sur un canal de communication (302), dans lequel chaque matrice (307) correspond à une matrice codée (306) d'une séquence de matrices codées (306) transmises sur le canal de communication (302), dans lequel le décodage de code polaire en escalier comprend deux ou plusieurs étapes de décodage, et dans lequel le procédé (1200) comprend une première étape de décodage des deux ou plusieurs étapes de décodage qui comprend :

la propagation (1201) de rapports de vraisemblance logarithmiques, LLR, d'une première matrice pour obtenir une première matrice LLR (900), dans lequel les LLR de la première matrice sont liés à une première matrice codée de la séquence de matrices codées (306) ;

l'entrelacement (1202) de la première matrice LLR (900) pour obtenir une première matrice entrelacée (902) ;

le préfixage (1203) de la première matrice entrelacée (902) à une deuxième matrice pour obtenir une première matrice préfixée, dans lequel la deuxième matrice est liée à une deuxième matrice codée de la séquence de matrices codées (306) ;

le décodage (1204) de chaque colonne de la première matrice préfixée à l'aide d'un algorithme de décodage de code polaire pour obtenir une première matrice décodée ;

le calcul (1205) d'une deuxième matrice mise à jour en ajoutant la première matrice décodée à une deuxième matrice LLR comprenant le LLR reçu en provenance du canal de communication après la transmission de la deuxième matrice codée ;

la réalisation d'une deuxième étape de décodage des deux ou plusieurs étapes de décodage par :

la propagation du LLR de la deuxième matrice mise à jour pour obtenir une troisième matrice LLR ;

l'entrelacement de la deuxième matrice LLR pour obtenir une deuxième matrice entrelacée ;

le préfixage de la deuxième matrice entrelacée à une troisième matrice pour obtenir une deuxième matrice préfixée, dans lequel la troisième matrice est liée à une troisième matrice codée de la séquence de matrices codées ;

le décodage de chaque colonne de la deuxième matrice préfixée à l'aide d'un algorithme de décodage de code polaire pour obtenir une deuxième matrice décodée ; et

le calcul d'une troisième matrice mise à jour en ajoutant la deuxième matrice décodée à une troisième matrice LLR comprenant le LLR reçu en provenance du canal de communication après la transmission de la troisième matrice codée ;

dans lequel le procédé comprend également l'entrelacement de la première matrice LLR ou de la deuxième matrice LLR en réalisant une rotation de 90° dans le sens des aiguilles d'une montre de la première ou de la deuxième matrice LLR et un décalage d'indice de colonne des positions de bits $x_{i,j}$ de chacune des lignes de la première ou de la deuxième matrice LLR tournée.

11. Programme informatique comprenant un produit de programme informatique permettant de réaliser le procédé (1100, 1200) selon la revendication 9 ou 10.

Fig. 1

Fig. 2

Fig. 3

EP 4 205 284 B1

| | | | | 0 | 0 | 0 | 0 |
|---|---|---|---|---|---|---|---|
| | | | | 0 | 0 | 0 | 0 |
| | | | | 0 | 0 | 0 | 1 |
| | | | | 0 | 0 | 1 | 0 |

| 0 | 0 | 1 | 0 | 0 | 0 | 0 | 0 |
|---|---|---|---|---|---|---|---|
| 0 | 0 | 1 | 1 | 0 | 0 | 0 | 0 |
| 0 | 0 | 0 | 0 | 1 | 0 | 0 | 0 |
| 0 | 0 | 1 | 1 | 0 | 1 | 1 | 1 |

| 0 | 0 | 1 | 1 | 0 | 0 | 0 | 0 |
|---|---|---|---|---|---|---|---|
| 0 | 0 | 0 | 0 | 0 | 0 | 0 | 0 |
| 0 | 0 | 1 | 0 | 0 | 0 | 0 | 1 |
| 0 | 0 | 0 | 1 | 1 | 0 | 0 | 0 |

| 0 | 0 | 1 | 1 | 0 | 0 | 0 | 0 |
|---|---|---|---|---|---|---|---|
| 0 | 0 | 1 | 0 | 0 | 0 | 0 | 0 |
| 0 | 0 | 1 | 0 | 1 | 0 | 0 | 1 |
| 0 | 0 | 1 | 1 | 1 | 0 | 1 | 1 |

$402 / X_0'$

$U_1 / 401$

$U_0^N / 801$

| 0 | 0 | 0 | 1 | 0 | 0 | 0 | 0 |
|---|---|---|---|---|---|---|---|
| 0 | 0 | 0 | 1 | 0 | 0 | 0 | 0 |
| 0 | 0 | 1 | 1 | 0 | 0 | 0 | 0 |
| 0 | 0 | 0 | 1 | 0 | 0 | 0 | 0 |

**Fig. 4**

Fig. 5

**Fig. 6**

**Fig. 7**

**Fig. 8**

EP 4 205 284 B1

Fig. 9

Pre-interleaving
$P_e$-based order

| 8 | 9 | 10 | 11 | 12 | 13 | 14 | 15 |

$\prod_{\text{pol}}^{\text{frz}}$

| 15 | 14 | 8 | 9 | 10 | 11 | 12 | 13 |

Frozen positions in **u**

Fig. 10

1100

1101 — generating

1102 — encoding

1103 — interleaving

1104 — transmitting

**Fig. 11**

1200

1201 — propagating

1202 — interleaving

1203 — prepending

1204 — decoding

1205 — computing

**Fig. 12**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CONDO CARLO et al.** Staircase Construction with Non-Systematic Polar Codes. *OPTICAL FIBER COMMUNICATIONS CONFERENCE AND EXHIBITION (OFC), OSA*, 1-3